# EUROPÄISCHE PATENTSCHRIFT

(11) **EP 3 451 301 B1**
(45) Veröffentlichungstag und Bekanntmachung des Hinweises auf die Patenterteilung: **31.07.2024**
(21) Anmeldenummer: 18192445.7
(22) Anmeldetag: 04.09.2018
(51) Int. Cl.: E05B 81/76, E05B 79/06, G07C 9/00

(54) **ZUGANGSSYSTEM FÜR EIN FAHRZEUG**
ACCESS SYSTEM FOR A VEHICLE
SYSTÈME D'ACCÈS POUR UN VÉHICULE

(30) Priorität: 05.09.2017 DE 102017120393
(43) Veröffentlichungstag der Anmeldung: 06.03.2019
(73) Patentinhaber: HUF Hülsbeck & Fürst GmbH & Co. KG, 42551 Velbert (DE)
(72) Erfinder: BECK, Andreas, 44795 Bochum (DE); WITTE, Martin, 48683 Ahaus (DE); BITIRIM, Serdal, 42549 Velbert (DE)
(74) Vertreter: Bals, Rüdiger

(56) Entgegenhaltungen:
- WO-A1-2018/091199
- DE-A1- 102016 112 418
- US-A1- 2005 057 047
- US-A1- 2009 256 677

## Beschreibung

Die vorliegende Erfindung betrifft ein Zugangssystem für ein Fahrzeug, insbesondere zur Aktivierung einer Fahrzeugfunktion. Ferner bezieht sich die Erfindung auf ein Verfahren für ein Fahrzeug.

Es ist aus dem Stand der Technik bekannt, dass tast- und/oder druckempfindliche Sensoren sowie Näherungssensoren bei einem Zugangssystem eines Fahrzeuges vorgesehen sein können. Derartige Sensoren können bspw. bei einem Türgriff eingesetzt werden, um eine Aktivierungshandlung, wie eine Berührung des Türgriffs, zu detektieren. Dabei sind die meisten Drucksensoren von außen zugänglich, um eine erfolgreiche Erfassung zu realisieren. Als Reaktion auf eine Detektion durch den entsprechenden Sensor kann eine Fahrzeugfunktion aktiviert werden, bspw. ein Aktivieren eines elektronischen Schlosses. Somit kann intuitiv durch die Berührung oder das Ziehen des Türgriffs einer Tür bspw. das Öffnen der Tür ermöglicht werden. Häufig kommen hierzu kapazitive Sensoren zum Einsatz.

Die US 2005/0057047 A1 offenbart ein Zugangssystem für ein Fahrzeug mit zwei induktiven Sensoren. Dabei wird der zweite Sensor nur dann aktiviert, wenn zuerst der erste Sensor aktiviert wird.

Nachteilhaft bei den bekannten Lösungen ist, dass die Auswertung der Erfassung der Sensoren aufwendig und technisch komplex ist. Insbesondere können Störeinflüsse, wie Umwelteinflüsse (z. B. Fahrzeugbewegungen oder Vibrationen am Fahrzeug) die Auswertung erschweren. Auch muss gewährleistet sein, dass im Crashfall keine Fehlauslösung des Sensors erfolgt. Hierzu werden oft mechanisch aufwendig konstruierte Sicherheitsvorrichtungen eingesetzt.

Es ist daher eine Aufgabe der vorliegenden Erfindung, die voranstehend beschriebenen Nachteile zumindest teilweise zu beheben. Insbesondere ist es eine Aufgabe der vorliegenden Erfindung, ein verbessertes Zugangssystem bereitzustellen, welches eine sicherere und/oder zuverlässigere und/oder komfortablere und/oder einfachere Möglichkeit zur Detektion einer Aktivierungshandlung bietet. Insbesondere sollen Fehlauslösungen und -detektionen des Sensors in technisch einfacher und kostengünstiger Weise verringert werden.

Die voranstehende Aufgabe wird gelöst durch ein Zugangssystem mit den Merkmalen des unabhängigen Systemanspruchs und durch ein Verfahren mit den Merkmalen des unabhängigen Verfahrensanspruchs. Weitere Merkmale und Details der Erfindung ergeben sich aus den jeweiligen Unteransprüchen, der Beschreibung und den Zeichnungen. Dabei gelten Merkmale und Details, die im Zusammenhang mit dem erfindungsgemäßen Zugangssystem beschrieben sind, selbstverständlich auch im Zusammenhang mit dem erfindungsgemäßen Verfahren, und jeweils umgekehrt, sodass bezüglich der Offenbarung zu den einzelnen Erfindungsaspekten stets wechselseitig Bezug genommen wird bzw. werden kann.

Die Aufgabe wird insbesondere gelöst durch ein Zugangssystem für ein Fahrzeug, vorzugsweise für ein Kraftfahrzeug und/oder Elektrofahrzeug und/oder Personenkraftfahrzeug und/oder selbstfahrendes (autonomes) Fahrzeug. Insbesondere dient das Zugangssystem zur Aktivierung einer Fahrzeugfunktion, vorzugsweise zur Aktivierung wenigstens eines elektrischen Schlosses, bspw. eines elektromechanischen Schlosses, des Fahrzeuges. Das jeweilige Schloss kann bspw. einem beweglichen Teil wie einer Tür des Fahrzeuges zugeordnet sein, um durch die Aktivierung das Öffnen des beweglichen Teils und damit den Zugang zum Fahrzeug für einen Bediener zu ermöglichen. Insbesondere ist eine Voraussetzung für die Aktivierung, dass eine Aktivierungshandlung erfolgreich detektiert wird und/oder dass eine erfolgreiche Authentifizierung des Bedieners stattgefunden hat und/oder dergleichen. Bspw. erfolgt dabei die Authentifizierung durch eine Kommunikation mit einem mobilen Identifikationsgeber (ID-Geber), wobei hier insbesondere ein Code-Austausch erfolgt. Alternativ oder zusätzlich kann wenigstens eine weitere Fahrzeugfunktion des Fahrzeuges durch das Zugangssystem bereitgestellt und/oder aktiviert werden, bspw. in Abhängigkeit von der Detektion der Aktivierungshandlung und/oder der Authentifizierung. Dies ermöglicht eine komfortable, sichere und vielseitige Steuerung von Funktionen des Fahrzeuges.

Es kann vorgesehen sein, dass das Zugangssystem wenigstens einen (z. B. innerhalb eines Türgriffkörpers angeordneten) Betätigungssensor aufweist, durch welchen eine erste Induktivitätserfassung zur Detektion, insbesondere Erfassung, einer Aktivierungshandlung durchführbar ist. Weiter kann das Zugangssystem wenigstens einen Informationssensor umfassen, durch welchen eine zweite Induktivitätserfassung durchführbar ist, sodass eine Zusatzinformation zur Aktivierungshandlung ermittelbar ist, wodurch die Detektion der Aktivierungshandlung plausibilisierbar ist. Das Plausibilisieren kann es dabei ermöglichen, die Korrektheit der Detektion der Aktivierungshandlung festzustellen. Eine positive Bestätigung der Detektion der Aktivierungshandlung setzt somit die erfolgreiche Plausibilisierung der Detektion voraus. Insbesondere in dem Fall, dass die erste Induktivitätserfassung nur scheinbar eine Aktivierungshandlung erkannt hat, was bspw. durch Störeinflüsse hervorgerufen werden kann, bewirkt die Plausibilisierung eine entsprechende Korrektur. Dies kann die Sicherheit und Zuverlässigkeit beim Betrieb des Zugangssystems deutlich verbessern.

Vorzugsweise unterscheidet sich dabei die zweite Induktivitätserfassung von der ersten Induktivitätserfassung hinsichtlich des Erfassungsbereiches. Bspw. wird die Zusatzinformation (z. B. zeitlich und/oder räumlich) unabhängig von der Aktivierungshandlung erfasst. Auch kann es möglich sein, dass durch die Induktivitätserfassung unterschiedliche Induktivitäten bzw. unterschiedliche Veränderungen der Induktivitäten erfasst werden. So kann es bspw. möglich sein, dass sich eine Aktivierungshandlung auf die erste Induktivitätserfassung signifikant auswirkt (sodass eine signifikante Induktivitätsveränderung erfasst wird), nicht jedoch auf die zweite Induktivitätserfassung (sodass die zweite Induktivitätserfassung nicht signifikant ist für die Aktivierungshandlung). In anderen Worten kann durch die erste Induktivitätserfassung eine Veränderung einer Induktivitätsveränderung erfasst werden, welche für die Aktivierungshandlung spezifisch ist, wohingegen die zweite Induktivitätserfassung beabsichtigt unspezifisch für die Aktivierungshandlung ist. Dies hat den Vorteil, dass in einfacher und zuverlässiger Weise eine Überprüfung (Plausibilisierung) der Detektion der Aktivierungshandlung erfolgen kann.

Der Erfindung liegt dabei insbesondere die Idee zugrunde, dass mehrere Sensoren (d. h. wenigstens ein Betätigungssensor und wenigstens ein Informationssensor) zum Einsatz kommen, um eine (einzige) Aktivierungshandlung zu detektieren. Insbesondere können die jeweiligen Sensoren getrennt voneinander durch entsprechende Sensorkanäle, insbesondere Signalkanäle, ausgewertet werden. Vorzugsweise dient der Informationssensor bzw. der Sensorkanal des Informationssensors dazu, ein Grundrauschen und/oder eine Grundbewegung des Fahrzeuges (und somit bspw. Umwelteinflüsse) zu erfassen. Die zweite Induktivitätserfassung kann somit insbesondere zur Detektion von Störeinflüssen auf die Aktivierungshandlung ausgeführt sein. Denn oft beeinflussen diese Störeinflüsse, welche durch den Informationssensor erfasst werden, auch die erste Induktivitätserfassung des Betätigungssensors. Letzterer dient dazu, die Aktivierungshandlung zu erfassen, um die Detektion zu ermöglichen. Insbesondere kann durch einen Vergleich der Ergebnisse der ersten und der zweiten Induktivitätserfassung eine Plausibilisierung der Detektion in einfacher Weise erfolgen.

Vorzugsweise weist dabei eine Erfassung einer Induktivitätsveränderung durch beide Sensoren in ähnlicher Höhe darauf hin, dass eben keine tatsächliche Aktivierungshandlung vorliegt, und die Detektion des Betätigungssensors somit nicht plausibel ist. Wenn hingegen die (erste) Induktivitätserfassung des Betätigungssensors sich stark von der (zweiten) Induktivitätserfassung des Informationssensors unterscheidet, kann ggf. auf eine Aktivierungshandlung geschlossen werden.

Bspw. umfasst die Aktivierungshandlung eine Verformung eines Teils des Fahrzeuges, bspw. eines Türgriffes, vorzugsweise eines feststehenden Türgriffs, bevorzugt in einem Aktivierungsbereich. insbesondere kann diese Deformation eine Induktivitätsveränderung hervorrufen, welche für die Aktivierungshandlung spezifisch ist. Dabei kann der Betätigungssensor derart benachbart zum Aktivierungsbereich angeordnet sein, dass sich diese Induktivitätsveränderung auf die erste Induktivitätserfassung auswirkt. Zudem kann der Informationssensor derart (z. B. benachbart zum Betätigungssensor) angeordnet sein, dass sich diese Induktivitätsveränderung durch die Aktivierungshandlung nicht signifikant oder nur geringfügiger oder zumindest anders auf die zweite Induktivitätserfassung auswirkt. Dies ermöglicht eine zuverlässige Plausibilisierung der Detektion, insbesondere durch einen Vergleich der ersten mit der zweiten Induktivitätserfassung.

Es ist dabei optional möglich, dass Sensorsignale der jeweiligen Sensoren (d. h. des Betätigungssensors und des Informationssensors) in regelmäßigen Zeitabständen gleichzeitig oder zeitlich versetzt ausgewertet werden, wobei die jeweilige Auswertung bspw. in zeitlichen Abständen im Bereich von 1 µs bis 5 s, vorzugsweise 10 µs bis 3 s, bevorzugt 100 µs bis 1 s, besonders bevorzugt 500 µs bis 800 µs erfolgt. Damit kann eine schnelle und komfortable Aktivierung des Zugangssystems ermöglicht werden.

Auch kann es möglich sein, dass der Informationssensor als ein Toggle-Geber ausgeführt ist, welcher ein Umschalten eines Auswertungsmodus für den Betätigungssensors und/oder für die Detektion der Aktivierungshandlung bewirkt. Bspw. ist es denkbar, dass bei einer Erfassung einer starken Induktivitätsveränderung des Informationssensors auf ein hohes Ausmaß von Störeinflüssen geschlossen werden kann. In diesem Fall kann, bspw. wenn die Messwerte der zweite Induktivitätserfassung einen Schwellenwert überschreiten, die Umschaltung des Auswertungsmodus von einem ersten Modus ("empfindlich") auf einen zweiten Modus ("unempfindlich") erfolgen. Entsprechend kann dann die Auswertung der erste Induktivitätserfassung gemäß dem Auswertungsmodus derart erfolgen, dass bspw. andere Schwellenwerte zur Detektion der Aktivierungshandlung genutzt werden. Entsprechend kann im Rahmen der Erfindung unter einer "Plausibilisierung" auch eine solche Beeinflussung der Detektion bzw. Auswertung verstanden werden.

Dabei kann es sich bei dem Betätigungssensor und dem Informationssensor um gleichartige und/oder in Bezug auf die Sensor-Spezifikationen identische Sensoren handeln, sodass insbesondere bei Nutzung gleicher Bauteile eine Kostenersparnis möglich ist. Weiter können, um bspw. die Sensitivität des Informationssensors zu erhöhen, auch unterschiedliche Sensoren vorgesehen sein. Bspw. kann die Empfindlichkeit für Vibrationen des Informationssensors erhöht sein. Alternativ oder zusätzlich kann eine höhere Empfindlichkeit des Informationssensors auch durch die Anordnung und/oder Lagerung des Informationssensors erzielt werden, welche bspw. bewegungsempfindlicher ausgeführt ist, als die des Betätigungssensors. Gemäß einem weiteren Vorteil kann die Lagerung des Informationssensors (ggf. im Gegensatz zum Betätigungssensor) nicht statisch erfolgen, sondern bspw. hängend (z. B. an einem Draht) oder (z. B. über Federelemente) frei und/oder elastisch beweglich. Insbesondere kann der Informationssensor dabei mit einem Federelement verbunden sein, welches zur Lagerung des Informationssensors am Fahrzeug (insbesondere in einem Innenraum des Türgriffs) dient, und ggf. den Informationssensor mit dem Fahrzeug (bzw. Türgriffkörper) verbindet. Dies ermöglicht eine einfache und zuverlässige Erfassung von Störeinwirkungen.

Optional ist das erfindungsgemäße Zugangssystem nicht auf zwei Sensoren beschränkt. So können ggf. noch weitere Betätigungssensoren und/oder Informationssensoren vorgesehen sein. Die Betätigungssensoren können dabei zur (redundanten) Detektion identischer Aktivierungshandlungen oder jeweils zur Detektion unterschiedlicher Aktivierungshandlungen ausgeführt sein, bspw. auch an unterschiedlichen Positionen und/oder an unterschiedlichen beweglichen Teilen und/oder unterschiedlichen Türgriffen des Fahrzeuges. Bevorzugt können die jeweiligen Betätigungssensoren dabei an diesen unterschiedlichen Positionen angeordnet sein, um die jeweilige Aktivierungshandlung zu detektieren. Auch die Informationssensoren können jeweils zur Plausibilisierung dieser jeweiligen identischen oder unterschiedlichen Detektionen ausgeführt sein, und entsprechend an unterschiedlichen Positionen des Fahrzeuges angeordnet sein. Die jeweiligen Betätigungs- und/oder Informationssensoren können dabei jeweils an oder in einem Türgriff und/oder an oder in einem beweglichen Teil und/oder benachbart hierzu, bspw. an einer Fahrzeugkarosserie, und/oder an oder in einem Türgriffträger und/oder an oder im Schloss und/oder an oder im Steuergerät für den Türgriff angeordnet sein. Das bewegliche Teil ist bspw. eine Tür oder Heckklappe des Fahrzeuges. Bspw. kann der jeweilige Sensor auch (ggf. unabhängig von einem Türgriff) hinter einer Verkleidung und/oder hinter einem Blech, insbesondere der Fahrzeugtür, oder dergleichen angeordnet sein, sodass dieser von außerhalb des Fahrzeuges nicht sichtbar angeordnet ist.

Optional ist es möglich, dass das Zugangssystem wenigstens einen Türgriff mit einem Türgriffkörper (insbesondere einen Türgriffträger) umfasst, wobei der Türgriffkörper mit einem Aktivierungsbereich ausgestaltet ist, sodass die Aktivierungshandlung durch einen Bediener am Türgriffkörper durchführbar ist. Bspw. ist der Aktivierungsbereich dadurch gebildet, dass dieser (anders als der daran angrenzende Bereich) eine (insbesondere definierte) Verformung bei Krafteinwirkung zulässt. Dies wird bspw. dadurch ermöglicht, dass eine Wandung (insbesondere des Türgriffkörpers) im Aktivierungsbereich eine Strukturanpassung wie eine bestimmte vorgegebene Dicke aufweist, und sich somit von der dazu benachbarten Wandung unterscheidet. Bspw. kann die Krafteinwirkung durch die Aktivierungshandlung, insbesondere durch eine Berührung, hervorgerufen werden. Dies ermöglicht eine einfach zu erfassende Detektion der Aktivierungshandlung sowie eine komfortable Durchführung derselben.

Weiter kann es möglich sein, dass der Türgriff als ein (insbesondere feststehender) Türaußengriff des Fahrzeuges ausgebildet ist, und vorzugsweise unbeweglich am Fahrzeug, insbesondere an einem beweglichen Teil (wie einer Tür oder einer Heckklappe) des Fahrzeuges, angebracht ist, wobei bevorzugt der Aktivierungsbereich als ein Deformationsbereich ausgeführt ist, und besonders bevorzugt der Türgriffkörper zumindest im Aktivierungsbereich elastisch verformbar ausgestaltet ist. Die Ausführung als Aktivierungs- bzw. Deformationsbereich kann bspw. dadurch erfolgen, dass eine Wandung des Türgriffkörpers im Deformationsbereich dünner ausgeführt ist bzw. eine Strukturanpassung im Vergleich zur benachbarten Wandung des Türgriffkörpers aufweist. Dies ermöglicht die Bereitstellung einer definierten Verformbarkeit zur zuverlässigen Detektion der Aktivierungshandlung.

Ferner ist es ggf. möglich, dass wenigstens ein Aktivierungsbereich am Fahrzeug, insbesondere an wenigstens einem Türgriff des Fahrzeuges, vorgesehen ist, in welchem die Aktivierungshandlung durch eine Krafteinwirkung durchführbar ist, sodass durch die Krafteinwirkung eine Verformung (bspw. eines Fahrzeugteils, wie einer Wandung eines Türgriffkörpers) im Aktivierungsbereich bewirkbar ist, wobei vorzugsweise der Betätigungssensor benachbart zum Aktivierungsbereich angeordnet, insbesondere befestigt, ist, und vorzugsweise auf den Aktivierungsbereich ausgerichtet ist, sodass durch die erste Induktivitätserfassung die Verformung erfassbar ist. Bspw. ist der Aktivierungsbereich dabei als Bereich des Fahrzeugteils, wie ein Bereich des Türgriffkörpers, ausgebildet. Insbesondere kann im Aktivierungsbereich ein Aktivierungsmittel vorgesehen sein, welche die Induktivitätsveränderung bei Verformung unterstützt. Bspw. ist der Betätigungssensor maximal 50 µm oder maximal 500 µm oder maximal 1 mm oder maximal 5 mm oder maximal 50 mm von der Wandung des Türgriffkörpers im Aktivierungsbereich und/oder von einem Aktivierungsmittel im Aktivierungsbereich beabstandet angeordnet. Das Aktivierungsmittel ist bspw. aus Metall ausgebildet, sodass es eine Veränderung der Induktivität bewirken kann.

Es kann optional möglich sein, dass eine (elektronische) Verarbeitungsvorrichtung vorgesehen ist, bspw. ein Mikrocontroller oder dergleichen, welche insbesondere derart mit dem Betätigungssensor und mit dem Informationssensor in elektrischer Wirkverbindung steht (z. B. kabelgebunden oder per Funk), dass zur Detektion der Aktivierungshandlung die Aktivierungshandlung durch eine (erste) Auswertung (durch die Verarbeitungsvorrichtung) der ersten Induktivitätserfassung erfassbar ist und anhand einer (zweiten) Auswertung (durch die Verarbeitungsvorrichtung) der zweiten Induktivitätserfassung die Plausibilisierung der Detektion der Aktivierungshandlung durchführbar ist. Dies ermöglicht eine einfache und schnelle Detektion der Aktivierungshandlung, insbesondere durch die Verarbeitungsvorrichtung. Hierzu kann die Verarbeitungsvorrichtung bspw. auch elektrisch mit einer zentralen Fahrzeugelektronik und/oder einem Steuergerät der Tür und/oder dergleichen verbunden sein. Bspw. kann die Verarbeitungsvorrichtung auch Teil der zentralen Fahrzeugelektronik oder dergleichen sein, und ist vorzugsweise somit in der Fahrzeugelektronik integriert. Auch kann die Verarbeitungsvorrichtung Teil eines Steuergeräts für die Tür oder für das Schloss sein. Insbesondere ist die Verarbeitungsvorrichtung mit einer Platine elektrisch verbunden und/oder darauf angeordnet, wobei vorzugsweise mit dieser Platine auch wenigstens einer der Sensoren elektrisch verbunden oder darauf angeordnet ist.

Außerdem kann es im Rahmen der Erfindung von Vorteil sein, wenn der wenigstens eine Betätigungssensor und/oder der wenigstens eine Informationssensor jeweils als LDC-Sensor und/oder induktiver Sensor oder dergleichen, insbesondere als (LDC-) Spule, ausgeführt ist, sodass vorzugsweise der jeweilige Sensor zur Induktivitätsmessung ausgeführt ist. Die Abkürzung LDC steht hierbei für "Inductance-To-Digital Converter bzw. Induktivität-DigitalUmsetzer. Der wenigstens eine Sensor dient dabei insbesondere zur (indirekten) Messung einer Verformung und/oder Relativbewegung und/oder einer Berührung eines benachbarten Fahrzeugteils, wie einer Wandung des Türgriffkörpers im Deformationsbereich bzw. Informationsbereich. Somit können zuverlässig die Deformationen erfasst bzw. Störeinflüsse erkannt werden.

Bevorzugt dient der wenigstens eine Betätigungssensor und/oder der wenigstens eine Informationssensor jeweils, insbesondere als ein LDC-Sensor, zur Erfassung von zumindest einer Veränderung einer Induktivität, d. h. insbesondere zur Induktivitätsmessung. Hierzu sind normalerweise verschiedene Bauteile und/oder Schaltkreise notwendig, welche insbesondere bei dem LDC-Sensor auf einem Chip, bzw. in einem integrierten Schaltkreis vereint sind. Der LDC-Sensor ist bspw. dazu aufgeführt, gleichzeitig die Impedanz und die Resonanzfrequenz eines LC-Schwingkreises zu messen. Hierbei ist der Sensor vorzugsweise unempfindlich gegenüber äußeren Einflüssen wie Feuchtigkeit oder Verunreinigung im Deformationsbereich bzw. Informationsbereich. Folglich kann zuverlässig eine Fehldetektion durch Einflüsse wie Regen, welche zu Störungen bei bspw. kapazitiven Sensoren führen, vermieden werden. Eine Fehldetektion durch äußere Einflüsse, welche eine Kraftausübung auf das Fahrzeugteil bewirken, kann dabei insbesondere durch eine (zweite) Auswertung des Informationssensors reduziert werden. Durch diese (zweite) Auswertung kann bspw. ein Schwellenwert oder dergleichen ermittelt werden. Insbesondere kann dann eine (erste) Auswertung des Betätigungssensors anhand des Schwellenwertes erfolgen, um Störeinflüsse zu unterdrücken. Der Schwellenwert dient somit zur Plausibilisierung der Detektion des Betätigungssensors. Der LDC-Sensor hat z. B. eine Auflösung unter einem Mikrometer (einer anhand der Induktivitätserfassung gemessenen Abstandsänderung) mit bspw. einer Bittiefe zur Quantisierung der gemessenen Induktivitätswerte von mindestens 16 Bit oder wenigstens 24 Bit.

Zudem ist im Rahmen der Erfindung denkbar, dass der Informationssensor als ein Crashsensor für das Fahrzeug ausgeführt ist. Bei einem Unfall treten ggf. hohe Beschleunigungen am Fahrzeug auf, welche somit (bspw. aufgrund der Verformung) eine Induktivitätsveränderung bei der ersten und/oder zweiten Induktivitätserfassung bewirken. Durch die Erfassung und/oder Auswertung einer entsprechend starken Induktivitätsveränderung durch den Informationssensor kann somit ggf. der Unfall, zumindest aber ein Störeinfluss, detektiert und von der Aktivierungshandlung unterschieden werden. Dies ermöglicht es, die erste Induktivitätserfassung entsprechend zu plausibilisieren, sodass die positive Detektion der Aktivierungshandlung bei einem Unfall verhindert werden kann. Insbesondere bewirkt die Erfassung von starken Induktivitätsveränderung und/oder eine hohen Frequenz der Induktivitätsveränderung der zweiten Induktivitätserfassung, dass die erfolgreiche Detektion der Aktivierungshandlung blockiert und ggf. Sicherheitsfunktionen des Fahrzeuges aktiviert werden (wie bspw. das Verriegeln des Schlosses oder dergleichen).

Ferner kann im Rahmen der Erfindung vorgesehen sein, dass der Betätigungssensor einen ersten Signalkanal und der Informationssensor einen zweiten Signalkanal aufweist, wobei sich der erste Signalkanal von dem zweiten Signalkanal unterscheidet, sodass insbesondere der Betätigungssensor über den ersten Signalkanal unabhängig von dem zweiten Signalkanal auswertbar ist, und vorzugsweise der Informationssensor über den zweiten Signalkanal unabhängig von dem ersten Signalkanal auswertbar ist. Insbesondere können somit zwei unterschiedliche Signale genutzt werden, und ggf. auch gleichzeitig ausgewertet werden, sodass eine schnelle und zuverlässige Plausibilisierung möglich ist. Die Nutzung separater Signalkanäle ermöglicht außerdem eine sichere Auswertung, sodass bspw. auch bei einer Störung eines der Signalkanäle weiterhin die Auswertung des anderen Signalkanals möglich ist. Dies ist bspw. auch bei der Nutzung des Informationssensors als Crashsensor relevant, wobei ggf. die positive Detektion einer Aktivierungshandlung (d. h. insbesondere die davon abhängige Aktivierung einer Fahrzeugfunktion) bei einer Störung des zweiten Signalkanals und/oder des Informationssensors stets verhindert ist.

Insbesondere kann es vorgesehen sein, dass der jeweilige Signalkanal als ein logischer Kanal ausgeführt ist, wobei die entsprechenden Signale z. B. physikalisch über ein (gemeinsames) Übertragungsmittel, wie ein elektrisches Kabel, übertragen werden. Hierzu kann bspw. auch ein Multiplex-Verfahren für die unterschiedlichen Signale zum Einsatz kommen. Alternativ kann der jeweilige Signalkanal auch als ein physikalischer (elektrischer/elektronischer) Kanal ausgeführt sein, wobei dann ein erster Signalkanal räumlich getrennt vom zweiten Signalkanal, z. B. als elektrische Leitung, ausgebildet ist. Ebenfalls ist es denkbar, dass der Betätigungssensor und/oder der Informationssensor separat von den jeweiligen Signalkanälen ausgeführt sind, sodass der Betätigungssensor elektrisch (und ggf. lösbar) mit dem ersten Signalkanal verbunden und/oder der Informationssensor elektrisch mit dem zweiten Signalkanal verbunden sind.

Weiter kann es möglich sein, dass der Informationssensor noch eine weitere Funktion (neben der Plausibilisierung) aufweist, welche durch die zweite Induktivitätserfassung bereitgestellt wird. Eine solche weitere Funktion kann bspw. eine Temperaturerfassung oder die Bereitstellung einer Information über eine Bewegung und/oder Verformung bei dem Fahrzeug sein. Dies hat den Vorteil, dass durch die Mehrfachfunktionalität eine deutliche Kostenreduzierung möglich ist.

Ein weiterer Vorteil im Rahmen der Erfindung ist erzielbar, wenn der Informationssensor beweglich an einem Türgriff, insbesondere in einem Innenraum des Türgriffs, angeordnet (insbesondere befestigt) ist, wobei vorzugsweise der Informationssensor relativ zu einer Wandung eines Türgriffkörpers des Türgriffs beweglich gelagert ist. Insbesondere erfolgt dabei die relativ zur Wandung bewegliche Lagerung derart, dass die durchschnittlich mögliche Relativbewegung (des Informationssensors zur Wandung) anhand der zweiten Induktivitätserfassung des Informationssensors signifikant von einem Stillstand (des Informationssensors relativ zur Wandung) unterschieden werden kann. Bspw. sind hierzu mindestens 5 oder mindestens 10 oder mindestens 20 oder mindestens 100 Abstufungen (d. h. entsprechend unterschiedliche Ausmaße bzw. Stärken) der Relativbewegung durch die zweite Induktivitätserfassung erfassbar und/oder unterscheidbar. So kann bspw. eine solche durchschnittlich mögliche Relativbewegung, welche mindestens eine Veränderung eines relativen Abstands des Informationssensor zur Wandung im Bereich von 1 µm bis 500 µm (vorzugsweise 11 µm bis 1000 µm) umfasst, von einem Stillstand oder einer solchen Relativbewegung mit einer maximalen Veränderung des Abstands im Bereich von 0,1 µm bis 10 µm unterschieden werden. Insbesondere handelt es sich dabei bei der Relativbewegung um eine Vibration, insbesondere des Informationssensors, welche entsprechend die zeitweise Veränderung des Abstands bewirkt.

Vorteilhaft ist es zudem, wenn mindestens ein oder mindestens zwei weitere Informationssensoren vorgesehen sind, wobei sämtliche Informationssensoren derart an und/oder in einem Türgriffkörper und/oder am Fahrzeug angeordnet sind, dass die zweite Induktivitätserfassung und entsprechende weitere Induktivitätserfassungen der weiteren Informationssensoren in jeweiligen Erfassungsbereichen durchführbar sind, wobei vorzugsweise sich die Erfassungsbereiche (räumlich) voneinander unterscheiden. Bspw. können die Erfassungsbereiche beabstandet voneinander am Fahrzeug vorgesehen sein, bspw. mindestens im Abstand von 10 cm oder mindestens 20 cm oder mindestens 1 m. Somit lassen sich ggf. auch unterschiedliche Störeinflüsse erfassen und zur Plausibilisierung nutzen.

Weiter ist im Rahmen der Erfindung denkbar, dass ein Türgriff mit einem Türgriffkörper vorgesehen ist, wobei der Türgriff wenigstens ein induktives und/oder metallisches Aktivierungsmittel aufweist, das in einem Aktivierungsbereich des Türgriffkörpers angeordnet ist, wobei vorzugsweise der Türgriffkörper im Aktivierungsbereich verformbar ausgestaltet ist, sodass durch die Aktivierungshandlung eine Beeinflussung des Aktivierungsmittels (insbesondere hinsichtlich einer Position des Aktivierungsmittels relativ zum Türgriffkörper) im Aktivierungsbereich bewirkbar ist. Vorzugsweise kann dabei der Erfassungsbereich des Informationssensors außerhalb oder zumindest teilweise innerhalb des Aktivierungsbereichs liegen. Bspw. erfolgt die Beeinflussung dadurch, dass die Position des Aktivierungsmittels verändert wird, d. h. das Aktivierungsmittel relativ zum Türgriffkörper bewegt wird. Hierdurch kann eine Induktivitätsveränderung hervorgerufen werden, welche durch die erste Induktivitätserfassung erfasst werden kann. Dies ermöglicht eine einfache und zuverlässige Erfassung der Aktivierungshandlung.

Es ist erfindungsgemäß, dass im Rahmen der Erfindung der Informationssensor derart am Fahrzeug angeordnet ist, insbesondere außerhalb einer signifikanten Einwirkung durch die Aktivierungshandlung (auf die durch den Informationssensor erfassbaren Induktivität), dass durch die zweite Induktivitätserfassung ein Störeinfluss auf die Detektion (insbesondere die Erfassung) der Aktivierungshandlung erfassbar ist. Beispielsweise kann es vorgesehen sein, dass der Informationssensor außerhalb des Türgriffs am Fahrzeug angeordnet ist, insbesondere an einem beweglichen Teil des Fahrzeuges, vorzugsweise an einer Tür des Fahrzeuges, und bevorzugt relativ zum beweglichen Teil beweglich gelagert ist. Insbesondere ist dabei auch der Türgriff am beweglichen Teil angeordnet, um ein Öffnen des beweglichen Teils zu ermöglichen.

Es ist ferner denkbar, dass ein Informationsbereich vorgesehen ist, insbesondere an einem Türgriff und/oder an einem beweglichen Teil, wobei der Informationssensor derart benachbart zum Informationsbereich angeordnet und/oder darauf ausgerichtet ist, dass eine Verformung und/oder Bewegung im Informationsbereich (d. h. auch eine Relativbewegung zwischen dem Informationssensor und dem Informationsbereich, z. B. durch eine Bewegung oder Vibration des Informationssensors selbst) durch die zweite Induktivitätserfassung ermittelbar ist, wobei vorzugsweise der Informationsbereich beabstandet zu einem Aktivierungsbereich für die Aktivierungshandlung angeordnet ist. Insbesondere kann dabei der Abstand mindestens 1 cm oder mindestens 10 cm oder mindestens 100 cm zwischen dem Aktivierungsbereich und dem Informationsbereich betragen. Dadurch kann gewährleistet werden, dass die Aktivierungshandlung nicht die zweite Induktivitätserfassung beeinflusst, um so eine zuverlässige Erfassung von Störeinflüssen zu ermöglichen.

Vorzugsweise umfasst der Informationsbereich wenigstens ein, insbesondere induktives und/oder metallisches, Informationsmittel. Bspw. ist der Informationsbereich zumindest teilweise innerhalb oder vollständig außerhalb des Aktivierungsbereiches (des Betätigungssensors) angeordnet.

Vorzugsweise ist das Informationsmittel und/oder das Aktivierungsmittel dazu ausgestaltet, seinen Induktivitätswert bei einer Verformung des Informationsmittels und/oder des Informationsbereiches bzw. des Aktivierungsmittels und/oder des Aktivierungsbereiches zu verändern. Bevorzugt kann dabei die Veränderung des Induktivitätswertes (auch) dadurch bewirkt werden, dass sich durch eine Krafteinwirkung auf den Informationsbereich bzw. den Aktivierungsbereich (durch die Aktivierungshandlung) ein Abstand des Informationsmittels bzw. Aktivierungsmittel zum Informationssensor bzw. Betätigungssensor verändert.

Weiter kann es im Rahmen der Erfindung möglich sein, dass der Betätigungssensor innerhalb des Türgriffkörpers (d. h. in einem Innenraum des Türgriffs, wobei der Innenraum durch den Türgriffkörper zumindest teilweise begrenzt wird) angeordnet ist, und vorzugsweise zur Detektion der Aktivierungshandlung derart beabstandet zu einem Aktivierungsmittel des Türgriffkörpers angeordnet ist, dass eine für die Aktivierungshandlung spezifische Verformung des Türgriffkörpers (im Aktivierungsbereich) durch die erste Induktivitätserfassung, insbesondere durch eine Messung einer Induktivität am Aktivierungsbereich, erfassbar ist. Dies kann den Vorteil erzielen, dass durch das Aktivierungsmittel das Ausmaß der Induktivitätsveränderung durch die Aktivierungshandlung angepasst und ggf. verstärkt werden kann, sodass eine Detektion mit ausreichender Empfindlichkeit möglich ist.

Des Weiteren kann es möglich sein, dass der Informationssensor innerhalb des Türgriffkörpers (insbesondere in einem Innenraum des Türgriffs) angeordnet ist, und vorzugsweise derart beabstandet zu einem Aktivierungsmittel und/oder einem Informationsmittel des Türgriffkörpers angeordnet ist, dass eine für die Aktivierungshandlung unspezifische Verformung des Türgriffkörpers und/oder Einwirkung auf einen Türgriffkörper durch die zweite Induktivitätserfassung, insbesondere durch eine Messung einer Induktivität am Aktivierungsbereich, erfassbar ist. Bspw. wird dabei das Aktivierungsmittel sowohl vom Informationssensor als auch vom Betätigungssensor genutzt, um die Induktivitätsveränderung aufgrund der Einwirkung bzw. Verformung im Aktivierungsbereich und/oder Informationsbereich zu erfassen. Das Informationsmittel kann dagegen unabhängig vom Aktivierungsmittel ausgebildet sein, z. B. räumlich beabstandet davon. Insbesondere erfasst der Informationssensor dabei, analog zum Betätigungssensor, eine Induktivität, insbesondere des Aktivierungsmittels bzw. Informationsmittels.

Insbesondere ist es für die Erfassung der Sensoren vorgesehen, dass im Aktivierungsbereich und/oder im Informationsbereich (jeweils) wenigstens ein induktives, insbesondere metallisches, Element vorgesehen ist, bspw. ein Aktivierungsmittel bzw. ein Informationsmittel. Das Aktivierungsmittel und/oder das Informationsmittel kann dabei bspw. ein Metallelement oder eine Metallschicht oder einen Metallstreifen oder eine Chromschicht aufweisen. So kann z. B. die Wandung im Aktivierungsbereich bzw. im Informationsbereich, welche bspw. überwiegend aus Kunststoff gebildet ist, ggf. keine signifikante Induktivitätsveränderung hervorrufen. Daher kann in einem solchen Fall ein Aktivierungsmittel im Deformationsbereich, insbesondere an oder in der Wandung, vorgesehen sein. Weiter kann vorzugsweise das Aktivierungsmittel und/oder das Informationsmittel an der Innenseite (d. h. fahrzeuginnenraumzugewandt) oder an der Außenseite (fahrzeuginnenraumabgewandt bzw. fahrzeugaußenbereichszugewandt) der Wandung angeordnet sein.

Es ist ebenfalls möglich, dass wenigstens einer der Sensoren jeweils zur Induktivitätsmessung an einem jeweiligen induktiven Aktivierungsmittel bzw. Informationsmittel ausgeführt ist. Insbesondere ist das Aktivierungsmittel im (jeweiligen) Aktivierungsbereich anordenbar ist, sodass vorzugsweise eine Deformation im jeweiligen Aktivierungsbereich anhand der ersten Induktivitätserfassung, insbesondere Induktivitätsmessung, erfassbar ist, um in Abhängigkeit von der Induktivitätserfassung die Aktivierungshandlung zu detektieren und/oder wenigstens eine Fahrzeugfunktion zu aktivieren. Bspw. kann jedes der Aktivierungsmittel bzw. Informationsmittel jeweils einem der Sensoren zugeordnet sein, und dazu bspw. relativ zum jeweilig zugeordneten Sensor in einem vorgegebenen Abstand angeordnet sein. Der Abstand muss dabei insbesondere derart gewählt werden, dass bei einer Bewegung des Aktivierungsmittels bzw. Informationsmittels es zu einer für den jeweiligen Sensor erfassbaren Induktivitätsveränderung kommt. Die Induktivitätsveränderung wird dabei insbesondere auch dadurch hervorgerufen, dass sich der Abstand für den entsprechenden Sensor zum Aktivierungsmittel bzw. Informationsmittel verändert. Bei dem Informationsmittel wird diese Änderung insbesondere durch Störeinflüsse hervorgerufen, wohingegen das Aktivierungsmittel zur Ausführung einer Relativbewegung zum Betätigungssensor bei einer manuellen Deformation durch einen Bediener ausgeführt ist.

Insbesondere kann es möglich sein, dass die erfolgreiche (positive) und damit auch erfolgreich plausibilisierte Detektion einer Aktivierungshandlung wenigstens eine Fahrzeugfunktion auslöst, wobei vorzugsweise die Fahrzeugfunktionen wenigstens eine der nachfolgenden Funktionen umfassen:
- Eine Freigabe oder ein Öffnen wenigstens einer Tür des Fahrzeuges, insbesondere durch eine Aktivierung eines elektrischen Schlosses der Tür,
- eine Ansteuerung einer Zentralverriegelung des Fahrzeuges,
- eine Freigabe oder Öffnen wenigstens einer Heckklappe des Fahrzeuges, insbesondere durch eine Aktivierung eines elektrischen Schlosses der Tür,
- ein Wecksignal für eine (zentrale) Fahrzeugverriegelung,
- eine Initiierung eines Authentifizierungsvorgangs,
- eine Freigabe oder Öffnen wenigstens einer Handschuhfachklappe des Fahrzeuges, insbesondere durch eine Aktivierung eines elektrischen Schlosses des Handschuhfachs,
- eine Aktivierung einer Fahrzeugbeleuchtung,
- eine Steuerung einer Bewegung des Fahrzeuges, bspw. einer Fahrtrichtung und/oder zur Initiierung eines Stoppens des Fahrzeuges, bspw. für eine Rangier- und/oder automatische Einparkfunktion des Fahrzeuges,
- eine Durchführung eines Notstopps bei dem Fahrzeug.

Ferner ist es optional vorgesehen, dass der Betätigungssensor an einer ersten Lagerstelle und der Informationssensor an einer zweiten Lagerstelle derart gelagert sind, insbesondere an einem Türgriff und/oder an einem beweglichen Teil des Fahrzeuges, dass der Informationssensor zur zweiten Lagerstelle einen größeren (insbesondere höher- und/oder hochfrequenten) Bewegungsspielraum aufweist als der Betätigungssensor zur ersten Lagerstelle, sodass der Betätigungssensor weniger vibrationsempfindlich ausgebildet ist als der Informationssensor. Bspw. ist dabei ein hochfrequenter Bewegungsspielraum vorgesehen, welcher z. B. Vibrationen ermöglicht. Insbesondere ist der Informationssensor bewusst empfindlich für Vibration ausgestaltet, um so Störungen besser zu detektieren. Bevorzugt kann auch eine zweite Verarbeitungsvorrichtung zur Auswertung der zweiten Induktivitätserfassung vorgesehen sein, wobei diese Auswertung bewusst empfindlich gegenüber Vibration ausgeführt ist.

Insbesondere kann es dabei auch möglich sein, dass der Informationssensor über eine elastisch ausgeführte Verbindung (insbesondere ein elastisches Haltemittel) mit seiner (zweiten) Lagerstelle verbunden ist, sodass eine Bewegung des Informationssensors relativ zur Lagerstelle möglich ist. Insbesondere kann diese Bewegung in mindestens einer oder zwei verschiedenen (z. B. orthogonal zueinander stehenden) Ebenen erfolgen. Bspw. kann das Haltemittel dabei als Federelement ausgeführt sein. Dies ermöglicht es in einfacher Weise, eine höhere Vibrationsempfindlichkeit des Informationssensors bereitzustellen.

Es ist ferner denkbar, dass der erste Betätigungssensor durch ein Festlager an einem Türgriff gelagert ist, und der Informationssensor dazu andersartig im Bereich des Türgriffs gelagert ist, vorzugsweise durch ein Loslager. Damit kann der Informationssensor speziell zur Detektion von Störeinflüssen ausgestaltet werden.

Ebenfalls Gegenstand der Erfindung ist ein Verfahren für ein Fahrzeug, insbesondere zur Aktivierung eines elektrischen Schlosses und/oder einer anderen Fahrzeugfunktion des Fahrzeuges. Hierbei werden insbesondere wenigstens ein Betätigungssensor und wenigstens ein Informationssensor genutzt und sind bspw. am Fahrzeug befestigt.

Es ist insbesondere vorgesehen, dass zumindest einer der nachfolgenden Schritte durchgeführt wird, wobei vorzugsweise die Schritte nacheinander oder in beliebiger Reihenfolge oder zumindest teilweise auch gleichzeitig durchgeführt werden, wobei bevorzugt einzelne Schritte auch wiederholt durchgeführt werden können:
a) Erfassen einer Verformung (insbesondere eines Türgriffkörpers eines Türgriffs) durch eine erste Induktivitätserfassung des Betätigungssensors,
b) Detektieren einer Aktivierungshandlung eines Bedieners durch eine erste Auswertung der ersten Induktivitätserfassung,
c) Ermitteln einer Zusatzinformation zur Aktivierungshandlung durch eine zweite Induktivitätserfassung des Informationssensors, insbesondere vor und/oder bei und/oder nach Schritt a),
d) Plausibilisieren der Detektion der Aktivierungshandlung durch eine zweite Auswertung anhand der Zusatzinformation, insbesondere vor Schritt b) oder nach Schritt b), bevorzugt so, dass eine positive Detektion der Aktivierungshandlung in Abhängigkeit von der Zusatzinformation durchgeführt wird, sodass insbesondere die Detektion gemäß Schritt b) positiv bestätigt wird oder die positive Detektion verhindert wird.

Damit bringt das erfindungsgemäße Verfahren die gleichen Vorteile mit sich, wie sie ausführlich mit Bezug auf ein erfindungsgemäßes Zugangssystem beschrieben worden sind. Zudem kann das Verfahren geeignet sein, ein erfindungsgemäßes Zugangssystem zu betreiben.

Gemäß einem weiteren Vorteil kann vorgesehen sein, dass durch die zweite Induktivitätserfassung Störeinflüsse auf die Detektion (insbesondere auf die Erfassung durch die erste Induktivitätserfassung) der Aktivierungshandlung und/oder Umgebungseinflüsse, vorzugsweise ein Grundrauschen und/oder eine Grundbewegung des Fahrzeuges, ermittelt werden. Dies ermöglicht eine besonders zuverlässige Detektion der Aktivierungshandlung.

Ferner ist es vorgesehen, dass das Plausibilisieren gemäß Schritt d) dadurch erfolgt, dass anhand der zweiten Induktivitätserfassung (z. B. durch die zweite Auswertung) ein Schwellenwert für die erste Auswertung zur Detektion festgelegt wird. Dieser kann bspw. durch die Verarbeitungsvorrichtung berücksichtigt werden, um die Aktivierungshandlung schnell und sicher zu detektieren. Dazu wird bspw. wenigstens ein Messwert der ersten Induktivitätserfassung mit dem Schwellenwert verglichen, um zu bestimmen, ob eine Aktivierungshandlung vorliegt. Ggf. können zusätzlich oder alternativ weitere Auswertungen erfolgen zur Plausibilisierung, bspw. eine Mittelung der Messwerte, eine statistische Analyse oder dergleichen.

Es ist ferner denkbar, dass durch die zweite Induktivitätserfassung eine Temperatur und/oder eine Verformung und/oder eine Vibration, insbesondere durch eine Messung einer Induktivitätsveränderung, ermittelt wird. Damit können in einfacher Weise noch weitere Funktionen bereitgestellt werden, welche ggf. auch zur Plausibilisierung oder für weitere Fahrzeugfunktionen genutzt werden.

Des Weiteren ist es denkbar, dass in Abhängigkeit von der zweiten Induktivitätserfassung die erste Auswertung der ersten Induktivitätserfassung beeinflusst wird, wobei insbesondere die erste Auswertung gemäß einer ersten Auswertungsart erfolgt, wenn die Zusatzinformation ein erstes Kriterium erfüllt, und die erste Auswertung gemäß einer zweiten Auswertungsart erfolgt, wenn die Zusatzinformation ein zweites Kriterium erfüllt. Bspw. kann dabei das erste und zweite Kriterium durch die Definition von Schwellenwerten bestimmt werden. So kann bspw. die erste Auswertungsart einem ersten Auswertungsmodus entsprechen, in welchem von einer normalen Empfindlichkeit für die Detektion der Aktivierungshandlung ausgegangen wird. Bspw. bei Vorliegen von starken Störeinflüssen, welche durch die zweite Induktivitätserfassung detektiert werden, kann eine Umschaltung von der ersten Auswertungsart zu einer zweiten Auswertungsart (entsprechend einem zweiten Auswertungsmodus) erfolgen. In dieser zweiten Auswertungsart kann dann die Empfindlichkeit zur Detektion der Aktivierungshandlung herabgesetzt werden. Das erste Kriterium, bspw. ein erster Schwellenwert für die Störeinflüsse, indiziert dabei bspw. einen geringen Einfluss der Störeinflüsse, und das zweite Kriterium, bspw. ein zweiter Schwellenwert für die Störeinflüsse, kann bspw. einen hohen Einfluss der Störeinflüsse indizieren. Dabei ist es auch denkbar, dass die Auswertung der Schwellenwerte und/oder Umschaltung im Rahmen der zweiten Auswertung erfolgt, und bspw. die erste Auswertung eines oder mehrerer Betätigungssensoren beeinflusst. Die erste Auswertung wird dabei z. B. in Abhängigkeit von der Auswertungsart durchgeführt.

Des Weiteren kann vorzugsweise die zweite Auswertung auch zeitlich vor und/oder bei und/oder nach der ersten Auswertung und/oder die zweite Induktivitätserfassung auch zeitlich vor und/oder bei und/oder nach der ersten Induktivitätserfassung erfolgen. Das erste und/oder zweite Kriterium wird bspw. dadurch festgelegt, dass wenigstens ein Schwellenwert und/oder ein Toleranzbereich und/oder eine Zustandsänderung bestimmt wird. Die Zustandsänderung umfasst bspw. die Aktivierung eines ersten Zustand (sodass das erste Kriterium erfüllt ist), in welchem die erste Auswertung normal durchgeführt wird, und somit auch eine Aktivierungshandlung positiv detektiert werden kann. Bspw. umfasst die Zustandsänderung auch einen zweiten Zustand (sodass das zweite Kriterium erfüllt ist), in welchem die zweite Auswertung derart durchgeführt wird, dass die positive Detektion der Aktivierungshandlung verhindert ist. In diesem Fall indiziert bspw. die Zusatzinformation eine starke Vibration am Fahrzeug, bspw. einen Crash, sodass vorteilhafterweise ein Aktivieren eines Schlosses oder dergleichen verhindert werden kann. Damit kann die Sicherheit beim Betrieb des Fahrzeuges deutlich erhöht werden.

Bevorzugt kann im Rahmen der Erfindung vorgesehen sein, dass bei einer positiven (erfolgreichen) Detektion der Aktivierungshandlung ein Öffnen eines elektrischen Schlosses initiiert wird, wobei insbesondere in Abhängigkeit von der zweiten Induktivitätserfassung das Öffnen blockiert wird, insbesondere im Crash-Fall und/oder bei einer Detektion von Störeinflüssen durch die zweite Auswertung, welche oberhalb eines Toleranzbereiches liegen. Der Toleranzbereich kann bspw. vordefiniert sein, sodass eine einfache Erfassung von Störeinflüssen möglich ist.

Optional ist es im Rahmen des erfindungsgemäßen Verfahrens möglich, dass an einem ersten Signalkanal ein erstes Signal des Betätigungssensors durch die erste Auswertung und an einen zweiten Signalkanal ein zweites Signal durch eine zweite Auswertung getrennt ausgewertet werden, wobei vorzugsweise ein erstes Signal abhängig von einer ersten Induktivitätserfassung und ein zweites Signal abhängig von einer zweiten Induktivitätserfassung ist. Dies ermöglicht es, durch die Trennung der Signalkanäle die Sicherheit beim Betrieb des Fahrzeuges weiter zu verbessern.

Außerdem kann es im Rahmen der Erfindung von Vorteil sein, dass zur Detektion von Störeinflüssen und/oder Umgebungseinflüssen eine Hüllkurve und/oder ein Verlauf und/oder eine statistische Information (durch eine statistische Analyse) eines zweiten Signals des Informationssensors ausgewertet werden, und bevorzugt zur Detektion der Aktivierungshandlung ein erstes Signal des Betätigungssensors direkt oder indirekt mit dem zweiten Signal und/oder dem Ergebnis der zweiten Auswertung verglichen wird. Bspw. kann hierzu die Verarbeitungsvorrichtung genutzt werden, um eine einfache und schnelle Detektion zu ermöglichen.

Weitere Vorteile, Merkmale und Einzelheiten der Erfindung ergeben sich aus der nachfolgenden Beschreibung, in der unter Bezugnahme auf die Zeichnungen Ausführungsbeispiele der Erfindung im Einzelnen beschrieben sind. Dabei können die in den Ansprüchen und in der Beschreibung erwähnten Merkmale jeweils einzeln für sich oder in beliebiger Kombination erfindungswesentlich sein. Es zeigen:
- Fig. 1: eine schematische Darstellung von Teilen eines erfindungsgemäßen Zugangssystems, wobei eine Vorderseite eines Türgriffkörpers perspektivisch gezeigt ist,
- Fig. 2: eine schematische Darstellung von Teilen eines erfindungsgemäßen Zugangssystems, wobei eine Rückseite eines Türgriffkörpers perspektivisch gezeigt ist,
- Fig. 3: eine weitere schematische Darstellung eines erfindungsgemäßen Zugangssystems,
- Fig. 4+5: schematische Anordnungen von Teilen eines erfindungsgemäßen Zugangssystems,
- Fig. 6+7: schematische Darstellungen in einer Schnittansicht durch einen Türgriffkörper,
- Fig. 8: eine schematische Darstellung einer Anordnung von Teilen eines erfindungsgemäßen Zugangssystems,
- Fig. 9: eine schematische Darstellung zur Visualisierung eines erfindungsgemäßen Verfahrens.

In den nachfolgenden Figuren werden für die gleichen technischen Merkmale auch von unterschiedlichen Ausführungsbeispielen die identischen Bezugszeichen verwendet.

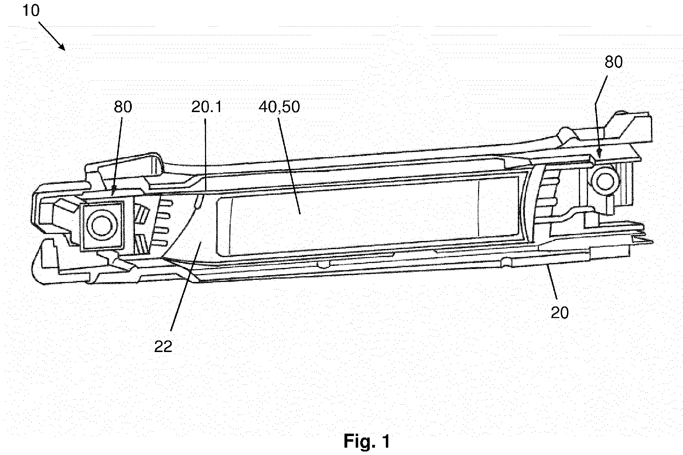

In Figur 1 sind schematisch Teile eines Türgriffs 10 eines erfindungsgemäßen Zugangssystems 200 gezeigt. Dieser umfasst u. a. einen Türgriffkörper 20, welcher in einer perspektivischen Vorderansicht dargestellt ist. Zu sehen ist damit die fahrzeugtürabgewandte Seite des Türgriffkörpers 20. Der gezeigte Türgriff 10 befindet sich dabei in Figur 1 im noch nicht fertig montierten Zustand. Somit ist auch eine Innenseite 20.1 des Türgriffkörpers 20 erkennbar, welche im montierten Zustand nicht mehr von außen zu sehen ist. Weiter sind auch Lagerstellen 80 bzw. Lagerungspunkte 80 für den Türgriffkörper 20 gezeigt. Der Türgriffkörper 20 umfasst des Weiteren eine Wandung 22, wobei der Türgriffkörper 20 zumindest teilweise als ein Spritzgussteil oder dergleichen ausgeführt ist und/oder aus Kunststoff ausgebildet ist.

Es kann dabei möglich sein, dass eine Betätigung des Türgriffs 10 durch eine (geringe) Krafteinwirkung durch einen Bediener 5 am Türgriff 10 erfolgt. Diese Krafteinwirkung kann durch eine Aktivierungshandlung, bspw. eine leichte Berührung durch eine Hand oder einen Finger des Bedieners 5, erfolgen. Insbesondere erfolgt dabei die Aktivierungshandlung in einem Aktivierungsbereich 40 des Türgriffs 10. Da eine Detektion der Aktivierungshandlung insbesondere auf eine Erfassung einer Verformung am Türgriff 10 basiert, kann der Aktivierungsbereich 40 bevorzugt als ein Deformationsbereich 40 ausgeführt sein, welcher eine (zumindest geringfügige und ggf. elastische) Deformation bei Krafteinwirkung zulässt. Hierzu ist der Deformationsbereich 40 bspw. mit einer Strukturanpassung 50 ausgeführt.

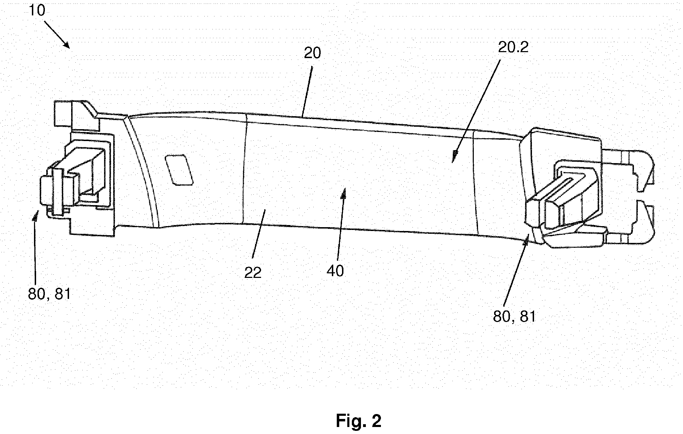

In Figur 2 ist schematisch eine Rückansicht des Türgriffkörpers 20 gezeigt, wobei eine Außenseite 20.2 des Türgriffkörpers 20 zu sehen ist. Diese Außenseite 20.2 kann im montierten Zustand zumindest teilweise eine Türgriffmulde begrenzen. Auch kann es möglich sein, dass (z. B. bei einem feststehenden Türgriff) eine solche Mulde nicht vorgesehen ist und/oder der Türgriffkörper 20 von der gezeigten Geometrie abweicht. Ebenfalls dargestellt sind des Weiteren die Lagerstellen 80 des Türgriffs 10, im Folgenden auch als erste Lagerstellen 81 bezeichnet. Außerdem ist der Aktivierungsbereich 40 gezeigt, wobei bspw. durch ein Hintergreifen des Türgriffs 10 durch den Bediener 5 (d. h. einem Hineinfassen in die Griffmulde) die Aktivierungshandlung durchgeführt werden kann. Dabei kann es auch möglich sein, dass die Berührung an einer anderen Stelle des Türgriffs 10, bspw. auf der Vorderseite, zur Durchführung der Aktivierungshandlung ausreichend ist.

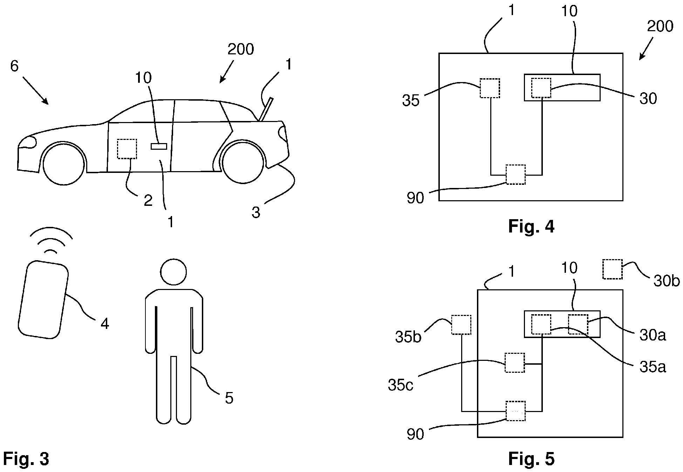

Figur 3 zeigt ein Fahrzeug 3 mit einem Türgriff 10, insbesondere einem Türaußengriff 10. Weiter sind bewegliche Teile 1 des Fahrzeuges 3 beispielhaft dargestellt, insbesondere eine Tür und eine Heckklappe. Schematisch ist auch ein elektrisches Schloss 2 eines Sicherheitssystems 6 des Fahrzeuges 3 gezeigt, welches bspw. dazu ausgeführt ist, ein Öffnen wenigstens einer der beweglichen Teile 1 im geschlossenen Zustand zu verhindern bzw. im geöffneten Zustand zu gestattet. Um bspw. den Zugang zum Fahrzeug 3 zu ermöglichen, kann ein Bediener 5 des Fahrzeuges 3 einen elektronischen Schlüssel (ID-Geber 4) nutzen, um eine Authentifizierung durchzuführen. Dies kann bspw. durch eine manuelle Betätigung des ID-Gebers 4 erfolgen oder automatisch bei einer Annäherung des ID-Gebers 4 an das Fahrzeug 4. Insbesondere kann die Authentifizierung auch dadurch ausgelöst werden, dass die Aktivierungshandlung (positiv) detektiert wird. Um nun bspw. eines der beweglichen Teile 1 zu öffnen, kann der Bediener 5 die Aktivierungshandlung am Türgriff 10 des entsprechenden beweglichen Teils 1 durchführen. Bei erfolgreicher Authentifizierung und Detektion kann dann das Öffnen des Schlosses 2 initiiert werden.

In Figur 4 und 5 ist schematisch dargestellt, dass am beweglichen Teil 1 bzw. an den beweglichen Teilen 1 des Fahrzeuges 3 jeweils wenigstens ein Betätigungssensor 30 und/oder jeweils ein Informationssensor 35 angeordnet sein können. Der Betätigungssensor 30 dient dabei insbesondere zur Detektion einer Aktivierungshandlung. Der Informationssensor 35 dient insbesondere zur Erfassung von Störeinflüssen auf die Detektion, um die Zuverlässigkeit der Detektion zu verbessern. Bspw. ist der Betätigungssensor 30 am oder im Türgriff 10 angeordnet. Ggf. kann dabei der Informationssensor 35 auch außerhalb des Türgriffs 10 und/oder außerhalb des beweglichen Teils 1 am Fahrzeug 3 angeordnet sein. In Figur 4 ist zu sehen, dass sowohl der Betätigungssensor 30 als auch der Informationssensor 35 mit einer Verarbeitungsvorrichtung 90 elektrisch oder per Funk verbunden sein können.

In Figur 5 ist gezeigt, dass auch mehrere Betätigungssensoren 30 und Informationssensoren 35 am Fahrzeug 3 vorgesehen sein können, insbesondere jeweils zur Aktivierung eines elektrischen Schlosses 2 eines bestimmten beweglichen Teils 1. So kann bspw. ein erster Betätigungssensor 30a am Türgriff 10 angeordnet sein, um einen Aktivierungsbereich 40 am Türgriff 10 zu überwachen. Ein zweiter Betätigungssensor 30b kann bspw. außerhalb des Türgriffs 10 und/oder außerhalb des beweglichen Teils 1 angeordnet sein, um eine Aktivierungshandlung außerhalb des Türgriffs 10 bzw. des beweglichen Teils 1 zu erfassen. Des Weiteren können ein erster Informationssensor 35a am Türgriff 10, ein zweiter Informationssensor 35b außerhalb des Türgriffs 10 und außerhalb des beweglichen Teils 1 und ein dritter Informationssensor 35c außerhalb des Türgriffs 10 und am beweglichen Teil 1 angeordnet sein. Insbesondere können diese Sensoren elektrisch oder per Funk mit einer gemeinsamen Verarbeitungsvorrichtung 90 verbunden sein. Dies ermöglicht eine umfangreiche und zuverlässige Auswertung von wenigstens einer Aktivierungshandlung, welche ggf. auch außerhalb des beweglichen Teils 1 erfolgen kann (z. B. benachbart dazu am Fahrzeug 3). Auch kann durch die Mehrzahl an Informationssensoren 35 eine umfassende Erfassung von Störeinflüssen erfolgen.

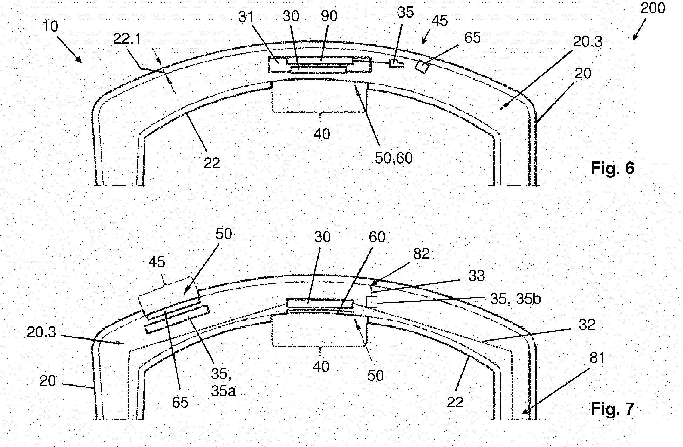

In Figur 6 und 7 werden Anordnungsbeispiele für einen Betätigungssensor 30 und einen Informationssensor 35 gezeigt. Dabei ist in der Schnittansicht durch den Türgriffkörper 20 deutlich die Wandung 22 des Türgriffkörpers 20 zu erkennen. Es ist gezeigt, dass diese überwiegend eine bestimmte Wandstärke 22.1 aufweist, welche bspw. größer ist als die Stärke der Wandung 22 im Bereich eines Aktivierungsbereiches 40. Um eine Deformation im Aktivierungsbereich 40 zu ermöglichen bzw. die Detektion dieser Deformation zu verbessern, kann im Aktivierungsbereich 40 bspw. eine Strukturanpassung 50, wie eine Ausnehmung 50 oder Materialschwächung 50, vorgesehen sein.

Der Betätigungssensor 30 und/oder der Informationssensor 35 können jeweils im Innenraum 20.3 des Türgriffkörpers 20 angeordnet sein. Bspw. kann eine Platine 31 vorgesehen sein, welche eine Elektronik umfasst, wie bspw. die Verarbeitungsvorrichtung 90. Insbesondere sind der Betätigungssensor 30 und/oder der Informationssensor 35 über jeweilige Signalkanäle und/oder elektrische Leitungen und/oder dergleichen mit der Platine 31 elektrisch verbunden.

In Figur 6 ist beispielhaft gezeigt, dass der Betätigungssensor 30 direkt an der Platine 31 angeordnet sein kann. Insbesondere ist der Betätigungssensor 30 dabei unbeweglich gelagert, sodass eine Relativbewegung zwischen dem Betätigungssensor 30 und der Platine 31 bzw. dem Türgriffkörper 20 (außerhalb des Aktivierungsbereiches 40) zumindest reduziert ist. Der Betätigungssensor 30 kann bspw. benachbart zu dem Aktivierungsbereich 40 angeordnet sein, um eine Deformation im Aktivierungsbereich 40 zu erfassen. Dies wird insbesondere dadurch ermöglicht, dass der Betätigungssensor 30 (wie auch der Informationssensor 35) dazu ausgeführt ist, eine Induktivitätserfassung durchzuführen. Bspw. sind der Betätigungssensor 30 und der Informationssensor 35 hierzu als LDC-Sensoren ausgeführt. Die Aktivierungshandlung bewirkt die Deformation und somit eine Veränderung der Induktivität, welche entsprechend durch den Betätigungssensor 30 erfasst werden kann. Um diese Detektion zu verbessern, insbesondere zu plausibilisieren, kann eine Zusatzinformation des Informationssensors 35 genutzt werden. Dieser ist insbesondere derart angeordnet, dass die Aktivierungshandlung keinen signifikanten Einfluss auf die Induktivitätserfassung des Informationssensors 35 hat. Damit kann der Informationssensor 35 dazu genutzt werden, Einflüsse zu erfassen, welche unabhängig von der Aktivierungshandlung am Türgriff 10 und/oder am Fahrzeug 3 auftreten, und ggf. die Detektion der Aktivierungshandlung durch den Betätigungssensor 30 stören können. Bspw. ist der Informationssensor 35 beabstandet vom Aktivierungsbereich 40 und/oder von der Platine 31 im Innenraum 20.3 angeordnet. Um die Erfassung von Störeinflüssen zu verbessern, kann der Informationssensor 35 bspw. derart beweglich gelagert sein, dass eine Relativbewegung zwischen dem Informationssensor 35 und der Platine 31 bzw. dem Türgriffkörper 20 stets möglich ist. Auch kann die Erfassung von Störeinflüssen dadurch verbessert werden, dass ein Informationsmittel 65 im Erfassungsbereich des Informationssensors 35 vorgesehen ist. Dieses bewirkt bei einer Veränderung des Abstands zwischen dem Informationssensor 35 und dem Informationsmittel 65 eine Induktivitätsveränderung, welche durch den Informationssensor 35 erfasst werden kann.

Um die Detektion der Aktivierungshandlung zu verbessern, kann außerdem ein Aktivierungsmittel 60 im Erfassungsbereich des Betätigungssensors 30 vorgesehen sein. Auch dieses kann bei einer Veränderung des Abstands zwischen dem Betätigungssensor 30 und dem Aktivierungsmittel 60 eine Induktivitätsveränderung bewirken, welche durch den Betätigungssensor 30 erfasst werden kann. Das Aktivierungsmittel 60 kann bspw. eine (metallische) Beschichtung der Wandung 22 im Aktivierungsbereich 40 sein, wie in Figur 6 dargestellt ist. Auch ist eine Ausbildung des Aktivierungsmittels 60 als separates Teil denkbar. Dies ist in Figur 7 schematisch gezeigt. Außerdem ist in Figur 7 zu sehen, dass die Lagerung des Betätigungssensors 30 auch unabhängig von der Platine 31 erfolgen kann, bspw. durch eine erste (insbesondere nicht-elastische, starre) Halterungsvorrichtung 32, welche den Betätigungssensor 30 mit der ersten Lagerstelle 81 des Türgriffs 10 verbindet.

Es kann weiter möglich sein, dass auch mehrere Informationssensoren 35 vorgesehen sind. Ein erster Informationssensor 35a ist in Figur 7 benachbart zu einem Informationsbereich 45 mit einem Informationsmittel 65 angeordnet. Auch im Informationsbereich 45 kann dabei eine Strukturanpassung 50 vorgesehen sein, um die Erfassung von Störeinflüssen zu verbessern.

Ein zweiter Informationssensor 35b kann bspw. über eine zweite (insbesondere elastische) Halterungsvorrichtung 33 mit einer zweiten Lagerstelle 82 am Türgriffkörper 20 verbunden sein. Die zweite Lagerstelle 82 ist bspw. als Loslager ausgeführt, sodass der zweite Informationssensor 35b beweglich gelagert ist.

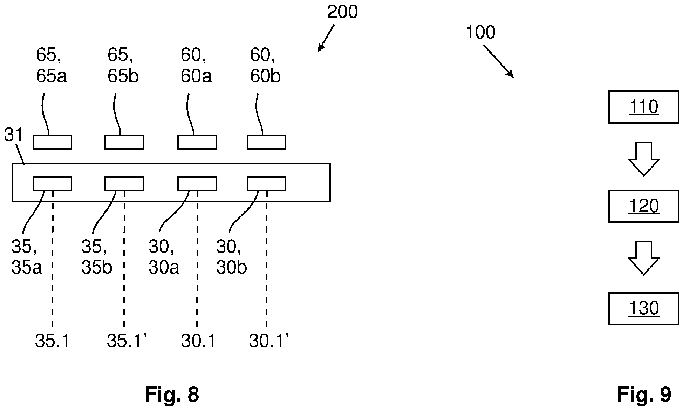

Eine weitere Möglichkeit einer Sensor-Anordnung ist in Figur 8 schematisch gezeigt. Dabei ist die Platine 31 dargestellt, an welcher ein erster Informationssensor 35a und ein zweiter Informationssensor 35b sowie ein erster Betätigungssensor 30a sowie ein zweiter Betätigungssensor 30b angeordnet, insbesondere unlösbar befestigt, sind. Der erste Betätigungssensor 30a kann dabei über einen ersten Signalkanal 30.1 und der zweite Betätigungssensor 30b über einen weiteren ersten Signalkanal 30.1' mit einer Verarbeitungsvorrichtung 90 verbunden sein. Der erste Informationssensor 35a kann über einen zweiten Signalkanal 35.1 und der zweite Informationssensor 35b über einen weiteren zweiten Signalkanal 35.1' mit der Verarbeitungsvorrichtung 90 verbunden sein. Die getrennte Ausführung der Signalkanäle ermöglicht dabei eine störungsfreie und zuverlässige Auswertung der Erfassungssignale.

Weiter ist gezeigt, dass für den erster Betätigungssensor 30a ein erstes Aktivierungsmittel 60a, für den zweiten Betätigungssensor 30b ein zweites Aktivierungsmittel 60b, für den ersten Informationssensor 35a ein erstes Informationsmittel 65a und für den zweiten Informationssensor 35b ein zweites Informationsmittel 65b vorgesehen sein können, um die jeweilige Erfassung zu verbessern und die Sensitivität zu erhöhen.

In Figur 9 ist schematisch ein erfindungsgemäßes Verfahren 100 visualisiert. Dabei kann zunächst ein Erfassen einer Verformung durch eine erste Induktivitätserfassung 110 des Betätigungssensors 30 erfolgen. Anschließend kann ein Detektieren einer Aktivierungshandlung eines Bedieners 5 durch eine erste Auswertung der ersten Induktivitätserfassung 110 durchgeführt werden. Außerdem kann ein Ermitteln einer Zusatzinformation zur Aktivierungshandlung durch eine zweite Induktivitätserfassung 120 des Informationssensors 35 durchgeführt werden, wobei dieses Ermitteln der Zusatzinformation zeitlich nach, gleichzeitig oder vor der ersten Induktivitätserfassung 100 erfolgen kann. Ferner kann das Ermitteln der Zusatzinformation noch dadurch verbessert werden, dass auch weitere Induktivitätserfassungen 130 durchgeführt werden, bspw. durch weitere Informationssensoren 35. Dies ermöglicht ein Plausibilisieren der Detektion der Aktivierungshandlung durch eine zweite Auswertung anhand der Zusatzinformation.

Die voranstehende Erläuterung der Ausführungsformen beschreibt die vorliegende Erfindung ausschließlich im Rahmen von Beispielen. Selbstverständlich können einzelne Merkmale der Ausführungsformen, sofern technisch sinnvoll, frei miteinander kombiniert werden, ohne den Rahmen der vorliegenden Erfindung zu verlassen.

### Bezugszeichenliste

- 1: bewegliches Teil
- 2: elektrisches Schloss
- 3: Fahrzeug
- 4: ID-Geber
- 5: Bediener
- 6: Sicherheitssystem

- 10: Türgriff, Türaußengriff

- 20: Türgriffkörper
- 20.1: Innenseite
- 20.2: Außenseite
- 20.3: Innenraum
- 22: Wandung
- 22.1: Wandstärke

- 30: Betätigungssensor
- 30a: erster Betätigungssensor
- 30b: zweiter Betätigungssensor

- 30.1: erster Signalkanal
- 30.1': weiterer erster Signalkanal

- 31: Platine
- 32: erste Halterungsvorrichtung
- 33: zweite Halterungsvorrichtung

- 35: Informationssensor
- 35a: erster Informationssensor
- 35b: zweiter Informationssensor
- 35c: dritter Informationssensor

- 35.1: zweiter Signalkanal
- 35.1': weiterer zweiter Signalkanal

- 40: Aktivierungsbereich, Deformationsbereich
- 45: Informationsbereich
- 50: Strukturanpassung, Ausnehmung, Materialschwächung

- 60: Aktivierungsmittel
- 60a: erstes Aktivierungsmittel
- 60b: zweites Aktivierungsmittel

- 65: Informationsmittel
- 65a: erstes Informationsmittel
- 65b: zweites Informationsmittel

- 80: Lagerstelle, Lagerungspunkt
- 81: erste Lagerstelle
- 82: zweite Lagerstelle

- 90: Verarbeitungsvorrichtung

- 100: Verfahren
- 110: erste Induktivitätserfassung
- 120: zweite Induktivitätserfassung
- 130: weitere Induktivitätserfassungen

- 200: Zugangssystem

## Patentansprüche

1. Zugangssystem (200) für ein Fahrzeug (3), insbesondere zur Aktivierung eines elektrischen Schlosses (2) des Fahrzeuges (3), aufweisend:
- wenigstens einen Betätigungssensor (30), durch welchen eine erste Induktivitätserfassung (110) zur Detektion einer Aktivierungshandlung durchführbar ist,
- wenigstens einen Informationssensor (35), durch welchen eine zweite Induktivitätserfassung (120) durchführbar ist, sodass eine Zusatzinformation zur Aktivierungshandlung ermittelbar ist, wodurch die Detektion der Aktivierungshandlung plausibilisierbar ist,
wobei der Informationssensor (35) derart am Fahrzeug (3) angeordnet ist, dass durch die zweite Induktivitätserfassung (120) ein Störeinfluss auf die Detektion der Aktivierungshandlung erfassbar ist, **dadurch gekennzeichnet, dass** das Plausibilisieren dadurch erfolgt, dass anhand der zweiten Induktivitätserfassung (120) ein Schwellenwert für eine Auswertung zur Detektion festgelegt wird.

2. Zugangssystem (200) nach dem vorhergehenden Anspruch,
**dadurch gekennzeichnet,**
**dass** das Zugangssystem (200) weiter umfasst:
- wenigstens einen Türgriff (10) mit einem Türgriffkörper (20), wobei der Türgriffkörper (20) mit einem Aktivierungsbereich (40) ausgestaltet ist, sodass die Aktivierungshandlung durch einen Bediener (5) am Türgriffkörper (20) durchführbar ist.

3. Zugangssystem (200) nach einem der vorhergehenden Ansprüche,
**dadurch gekennzeichnet,**
**dass** ein Aktivierungsbereich (40) am Fahrzeug (3) vorgesehen ist, in welchem die Aktivierungshandlung durch eine Krafteinwirkung durchführbar ist, sodass durch die Krafteinwirkung eine Verformung im Aktivierungsbereich (40) bewirkbar ist, wobei der Betätigungssensor (30) benachbart zum Aktivierungsbereich (40) angeordnet ist, sodass durch die erste Induktivitätserfassung (110) die Verformung erfassbar ist.

4. Zugangssystem (200) nach einem der vorhergehenden Ansprüche,
**dadurch gekennzeichnet,**
**dass** eine Verarbeitungsvorrichtung (90) vorgesehen ist, welche derart mit dem Betätigungssensor (30) und mit dem Informationssensor (35) in elektrischer Wirkverbindung steht, dass zur Detektion der Aktivierungshandlung die Aktivierungshandlung durch eine Auswertung der ersten Induktivitätserfassung (110) erfassbar ist und anhand einer Auswertung der zweiten Induktivitätserfassung (120) plausibilisierbar ist.

5. Zugangssystem (200) nach einem der vorhergehenden Ansprüche,
**dadurch gekennzeichnet,**
**dass** der Betätigungssensor (30) und der Informationssensor (35) jeweils als LDC-Sensor (30, 35) ausgeführt sind
und/oder dass der Betätigungssensor (30) einen ersten Signalkanal (30.1) und der Informationssensor (35) einen zweiten Signalkanal (35.1) aufweist, wobei sich der erste Signalkanal (30.1) von dem zweiten Signalkanal (35.1) unterscheidet, sodass insbesondere der Betätigungssensor (30) über den ersten Signalkanal (30.1) unabhängig von dem zweiten Signalkanal (35.1) auswertbar ist, und vorzugsweise der Informationssensor (35) über den zweiten Signalkanal (35.1) unabhängig von dem ersten Signalkanal (30.1) auswertbar ist.

6. Zugangssystem (200) nach einem der vorhergehenden Ansprüche,
**dadurch gekennzeichnet,**
**dass** der Informationssensor (35) als ein Crashsensor für das Fahrzeug (3) ausgeführt ist und/oder dass der Informationssensor (35) beweglich an einem Türgriff (10), insbesondere in einem Innenraum (20.3) des Türgriffs (10), angeordnet ist, wobei vorzugsweise der Informationssensor (35) relativ zu einer Wandung (22) eines Türgriffkörpers (20) des Türgriffs (10) beweglich gelagert ist
und/oder dass mindestens ein oder mindestens zwei weitere Informationssensoren (35b, 35c) vorgesehen sind, wobei sämtliche Informationssensoren (35) derart an und/oder in einem Türgriffkörper (20) und/oder am Fahrzeug (3) angeordnet sind, dass die zweite Induktivitätserfassung (120) und entsprechende weitere Induktivitätserfassungen (130) der weiteren Informationssensoren (35b, 35c) in jeweiligen Erfassungsbereichen durchführbar sind, wobei sich die Erfassungsbereiche voneinander unterscheiden.

7. Zugangssystem (200) nach einem der vorhergehenden Ansprüche,
**dadurch gekennzeichnet,**
**dass** ein Türgriff (10) mit einem Türgriffkörper (20) vorgesehen ist, wobei der Türgriff (10) wenigstens ein induktives Aktivierungsmittel (60) aufweist, das in einem Aktivierungsbereich (40) des Türgriffkörpers (20) angeordnet ist, wobei der Türgriffkörper (20) im Aktivierungsbereich (40) verformbar ausgestaltet ist, sodass durch die Aktivierungshandlung eine Beeinflussung des Aktivierungsmittels (60) im Aktivierungsbereich (40) bewirkbar ist.

8. Zugangssystem (200) nach einem der vorhergehenden Ansprüche,
**dadurch gekennzeichnet,**
**dass** der Informationssensor (35) außerhalb einer signifikanten Einwirkung der Aktivierungshandlung am Fahrzeug (3) angeordnet ist, und/oder dass der Informationssensor (35) außerhalb des Türgriffs (10) am Fahrzeug (3) angeordnet ist, insbesondere an einem beweglichen Teil (1) des Fahrzeuges (3), vorzugsweise an einer Tür (1) des Fahrzeuges (3), und bevorzugt relativ zum beweglichen Teil (1) beweglich gelagert ist.

9. Zugangssystem (200) nach einem der vorhergehenden Ansprüche,
**dadurch gekennzeichnet,**
**dass** ein Informationsbereich (45) vorgesehen ist, insbesondere an einem Türgriff (10) und/oder an einem beweglichen Teil (1) des Fahrzeuges (3), wobei der Informationssensor (35) derart benachbart zum Informationsbereich (45) angeordnet ist, dass eine Verformung und/oder Bewegung im Informationsbereich (45) durch die zweite Induktivitätserfassung (120) ermittelbar ist, wobei vorzugsweise der Informationsbereich (45) beabstandet zu einem Aktivierungsbereich (40) für die Aktivierungshandlung angeordnet ist.

10. Zugangssystem (200) nach einem der vorhergehenden Ansprüche,
**dadurch gekennzeichnet,**
**dass** der Betätigungssensor (30) an einer ersten Lagerstelle (81) und der Informationssensor (35) an einer zweiten Lagerstelle (82) derart gelagert sind, insbesondere an einem Türgriff (10) und/oder an einem beweglichen Teil (1) des Fahrzeuges (3), dass der Informationssensor (35) zur zweiten Lagerstelle (82) einen größeren Bewegungsspielraum aufweist als der Betätigungssensor (30) zur ersten Lagerstelle (81), sodass der Betätigungssensor (30) weniger vibrationsempfindlich ausgebildet ist als der Informationssensor (35)
und/oder dass der erste Betätigungssensor (30) durch ein Festlager an einem Türgriff (10) gelagert ist, und der Informationssensor (35) dazu andersartig im Bereich des Türgriffs (10) gelagert ist, vorzugsweise durch ein Loslager.

11. Verfahren (100) für ein Fahrzeug (3), insbesondere zur Aktivierung eines elektrischen Schlosses (2) des Fahrzeuges (3), wobei wenigstens ein Betätigungssensor (30) und wenigstens ein Informationssensor (35) vorgesehen sind,
**wobei die nachfolgenden Schritte vorgesehen sind:**
a) Erfassen einer Verformung durch eine erste Induktivitätserfassung (110) des Betätigungssensors (30),
b) Detektieren einer Aktivierungshandlung eines Bedieners (5) durch eine erste Auswertung der ersten Induktivitätserfassung (110),
c) Ermitteln einer Zusatzinformation zur Aktivierungshandlung durch eine zweite Induktivitätserfassung (120) des Informationssensors (35),
d) Plausibilisieren der Detektion der Aktivierungshandlung durch eine zweite Auswertung anhand der Zusatzinformation,
wobei der Informationssensor (35) derart am Fahrzeug (3) angeordnet ist, dass durch die zweite Induktivitätserfassung (120) ein Störeinfluss auf die Detektion der Aktivierungshandlung erfassbar ist, **dadurch gekennzeichnet, dass** das Plausibilisieren gemäß Schritt d) dadurch erfolgt, dass anhand der zweiten Induktivitätserfassung (120) ein Schwellenwert für die erste Auswertung zur Detektion festgelegt wird.

12. Verfahren (100) nach Anspruch 11,
**dadurch gekennzeichnet,**
**dass** durch die zweite Induktivitätserfassung (120) Umgebungseinflüsse, vorzugsweise ein Grundrauschen und/oder eine Grundbewegung des Fahrzeuges (3), ermittelt werden und/oder dass durch die zweite Induktivitätserfassung (120) eine Temperatur und/oder eine Verformung und/oder eine Vibration, insbesondere durch eine Messung einer Induktivitätsveränderung, ermittelt wird.

13. Verfahren (100) nach einem der Ansprüche 11 oder 12,
**dadurch gekennzeichnet,**
**dass** in Abhängigkeit von der zweiten Induktivitätserfassung (120) die erste Auswertung der ersten Induktivitätserfassung (110) beeinflusst wird, wobei insbesondere die erste Auswertung gemäß einer ersten Auswertungsart erfolgt, wenn die Zusatzinformation ein erstes Kriterium erfüllt, und die erste Auswertung gemäß einer zweiten Auswertungsart erfolgt, wenn die Zusatzinformation ein zweites Kriterium erfüllt.

14. Verfahren (100) nach einem der Ansprüche 11 bis 13,
**dadurch gekennzeichnet,**
**dass** bei einer positiven Detektion der Aktivierungshandlung ein Öffnen eines elektrischen Schlosses (2) initiiert wird, wobei insbesondere in Abhängigkeit von der zweiten Induktivitätserfassung (120) das Öffnen blockiert wird, insbesondere im Crash-Fall und/oder bei einer Detektion von Störeinflüssen durch die zweite Auswertung, welche oberhalb eines Toleranzbereiches liegen
und/oder dass zur Detektion von Störeinflüssen und/oder Umgebungseinflüssen eine Hüllkurve und/oder ein Verlauf und/oder eine statistische Information eines zweiten Signals des Informationssensors (35) ausgewertet werden, und bevorzugt zur Detektion der Aktivierungshandlung ein erstes Signal des Betätigungssensors (30) direkt oder indirekt mit dem zweiten Signal und/oder dem Ergebnis der zweiten Auswertung verglichen wird.

15. Verfahren (100) nach einem der Ansprüche 11 bis 14,
**dadurch gekennzeichnet,**
**dass** ein Zugangssystem (200) nach einem der vorhergehenden Ansprüche betreibbar ist.

## Claims

1. Access system (200) for a vehicle (3), in particular for activating an electric lock (2) of the vehicle (3):
- at least one actuation sensor (30), by means of which a first inductance detection (110) can be carried out to detect an activation action,
- at least one information sensor (35), by means of which a second inductance detection (120) can be carried out, so that additional information on the activation action can be determined, whereby the detection of the activation action can be made plausible,
wherein the information sensor (35) is arranged on the vehicle (3) in such a way that a disturbance influence on the detection of the activation action can be detected by the second inductance detection (120),
**characterized in that**
the plausibility check is carried out by using the second inductance detection (120) to determine a threshold value for an evaluation for detection.

2. Access system (200) according to the preceding claim,
**characterized in that**
the access system (200) further comprises:
- at least one door handle (10) with a door handle body (20), wherein the door handle body (20) is designed with an activation area (40), so that the activation action can be carried out by an operator (5) on the door handle body (20).

3. Access system (200) according to any one of the preceding claims,
**characterized in that**
an activation area (40) is provided on the vehicle (3), in which the activation action can be carried out by an application of force, so that a deformation in the activation area (40) can be brought about by the application of force, wherein the actuation sensor (30) is arranged adjacent to the activation area (40), so that the deformation can be detected by the first inductance detection (110).

4. Access system (200) according to any one of the preceding claims,
**characterized in that**
a processing device (90) is provided, which is in electrical operative connection with the actuation sensor (30) and with the information sensor (35) in such a way that, in order to detect the activation action, the activation action can be detected by an evaluation of the first inductance detection (110) and can be made plausible by means of an evaluation of the second inductance detection (120).

5. Access system (200) according to any one of the preceding claims,
**characterized in that**
the actuation sensor (30) and the information sensor (35) are each designed as an LDC sensor (30, 35)
and/or **in that** the actuation sensor (30) has a first signal channel (30.1) and the information sensor (35) has a second signal channel (35.1), the first signal channel (30.1) differing from the second signal channel (35.1), so that in particular the actuation sensor (30) can be evaluated via the first signal channel (30.1) independently of the second signal channel (35.1), and preferably the information sensor (35) can be evaluated via the second signal channel (35.1) independently of the first signal channel (30.1).

6. Access system (200) according to any one of the preceding claims,
**characterized in that**
the information sensor (35) is designed as a crash sensor for the vehicle (3) and/or **in that** the information sensor (35) is arranged movably on a door handle (10), in particular in an interior (20.3) of the door handle (10), the information sensor (35) preferably being mounted movably relative to a wall (22) of a door handle body (20) of the door handle (10)
and/or **in that** at least one or at least two further information sensors (35b, 35c) are provided, all the information sensors (35) being arranged on and/or in a door handle body (20) and/or on the vehicle (3) in such a way that the second inductance detection (120) and corresponding further inductance detections (130) of the further information sensors (35b, 35c) can be carried out in respective detection areas, the detection areas differing from one another.

7. Access system (200) according to any one of the preceding claims,
**characterized in that**
a door handle (10) with a door handle body (20) is provided, the door handle (10) having at least one inductive activation means (60) which is arranged in an activation area (40) of the door handle body (20), the door handle body (20) being designed to be deformable in the activation area (40), so that the activation action can bring about an influencing of the activation means (60) in the activation area (40).

8. Access system (200) according to any one of the preceding claims,
**characterized in that**
the information sensor (35) is arranged on the vehicle (3) outside a significant effect of the activation action, and/or **in that** the information sensor (35) is arranged on the vehicle (3) outside the door handle (10), in particular on a movable part (1) of the vehicle (3), preferably on a door (1) of the vehicle (3), and is preferably mounted movably relative to the movable part (1).

9. Access system (200) according to any one of the preceding claims,
**characterized in that**
an information region (45) is provided, in particular on a door handle (10) and/or on a moving part (1) of the vehicle (3), the information sensor (35) being arranged adjacent to the information region (45) in such a way that a deformation and/or movement in the information region (45) can be determined by the second inductance detection (120), the information region (45) preferably being arranged at a distance from an activation area (40) for the activation action.

10. Access system (200) according to any one of the preceding claims,
**characterized in that**
the actuation sensor (30) is mounted on a first bearing point (81) and the information sensor (35) is mounted on a second bearing point (82), in particular on a door handle (10) and/or on a movable part (1) of the vehicle (3), in such a way that the information sensor (35) has a greater range of movement relative to the second bearing point (82) than the actuation sensor (30) relative to the first bearing point (81), so that the actuation sensor (30) is designed to be less sensitive to vibration than the information sensor (35) and/or **in that** the first actuation sensor (30) is mounted on a door handle (10) by means of a fixed bearing, and the information sensor (35) is mounted in a different manner in the region of the door handle (10), preferably by means of a floating bearing.

11. Method (100) for a vehicle (3), in particular for activating an electric lock (2) of the vehicle (3), wherein at least one actuation sensor (30) and at least one information sensor (35) are provided,
**whereby the following stages are provided:**
a) Detection of a deformation by a first inductance detection (110) of the actuation sensor (30),
b) Detection of an activation action of an operator (5) by a first evaluation of the first inductance detection (110),
c) Determining additional information on the activation action by a second inductance detection (120) of the information sensor (35),
d) Plausibility check of the detection of the activation action by a second evaluation using the additional information,
wherein the information sensor (35) is arranged on the vehicle (3) in such a way that a disturbance influence on the detection of the activation action can be detected by the second inductance detection (120),
**characterized in that**
the plausibility check according to step d) is carried out by determining a threshold value for the first evaluation for detection on the basis of the second inductance detection (120).

12. Method (100) according to claim 11,
**characterized in that**
the second inductance detection (120) is used to determine environmental influences, preferably a background noise and/or a background movement of the vehicle (3) and/or that a temperature and/or a deformation and/or a vibration is determined by the second inductance detection (120), in particular by measuring a change in inductance.

13. Method (100) according to any one of claims 11 or 12,
**characterized in that**
the first evaluation of the first inductance detection (110) is influenced as a function of the second inductance detection (120), in particular the first evaluation being performed in accordance with a first type of evaluation if the additional information fulfills a first criterion, and the first evaluation being performed in accordance with a second type of evaluation if the additional information fulfills a second criterion.

14. Method (100) according to any one of claims 11 to 13,
**characterized in that**
an opening of an electric lock (2) is initiated in the event of a positive detection of the activation action, the opening being blocked in particular as a function of the second inductance detection (120), in particular in the event of a crash and/or in the event of a detection of interference influences by the second evaluation which lie above a tolerance range
and/or **in that** an envelope curve and/or a course and/or statistical information of a second signal of the information sensor (35) are evaluated for the detection of interfering influences and/or environmental influences, and preferably a first signal of the actuation sensor (30) is compared directly or indirectly with the second signal and/or the result of the second evaluation for the detection of the activation action.

15. Method (100) according to any one of claims 11 to 14,
**characterized in that**
an access system (200) according to one of the preceding claims is operable.

## Revendications

1. Système d'accès (200) pour un véhicule (3), en particulier pour l'activation d'une serrure électrique (2) du véhicule (3) :
- au moins un capteur d'actionnement (30), par lequel une première détection d'inductance (110) peut être effectuée pour la détection d'une action d'activation,
- au moins un capteur d'information (35), par lequel une deuxième détection d'inductance (120) peut être effectuée, de sorte qu'une information supplémentaire concernant l'action d'activation peut être déterminée, ce qui permet de rendre plausible la détection de l'action d'activation,
le capteur d'information (35) étant disposé sur le véhicule (3) de telle sorte qu'une influence perturbatrice sur la détection de l'action d'activation peut être détectée par la deuxième détection d'inductance (120),
**caractérisé en ce que**
le contrôle de plausibilité s'effectue **en ce que**, à l'aide de la deuxième détection d'inductance (120), une valeur seuil est fixée pour une évaluation en vue de la détection.

2. Système d'accès (200) selon la revendication précédente,
**caractérisé en ce que**
le système d'accès (200) comprend en outre
- au moins une poignée de porte (10) avec un corps de poignée de porte (20), le corps de poignée de porte (20) étant configuré avec une zone d'activation (40), de sorte que l'action d'activation peut être exécutée par un opérateur (5) sur le corps de poignée de porte (20).

3. Système d'accès (200) selon l'une quelconque des revendications précédentes,
**caractérisé en ce qu'**
il est prévu sur le véhicule (3) une zone d'activation (40) dans laquelle l'action d'activation peut être exécutée par l'action d'une force, de sorte qu'une déformation peut être provoquée dans la zone d'activation (40) par l'action d'une force, sachant que le capteur d'actionnement (30) est disposé au voisinage de la zone d'activation (40), de sorte que la déformation peut être détectée par la première détection d'inductance (110).

4. Système d'accès (200) selon l'une quelconque des revendications précédentes,
**caractérisé en ce qu'**
il est prévu un dispositif de traitement (90) qui est en liaison active électrique avec le capteur d'actionnement (30) et avec le capteur d'information (35) de telle sorte que, pour la détection de l'action d'activation, l'action d'activation peut être détectée par une évaluation de la première détection d'inductance (110) et peut être rendue plausible à l'aide d'une évaluation de la deuxième détection d'inductance (120).

5. Système d'accès (200) selon l'une quelconque des revendications précédentes,
**caractérisé en ce que**
le capteur d'actionnement (30) et le capteur d'information (35) sont chacun réalisés sous forme de capteur LDC (30, 35)
et/ou **en ce que** le capteur d'actionnement (30) présente un premier canal de signal (30.1) et le capteur d'information (35) un deuxième canal de signal (35.1), le premier canal de signal (30.1) étant différent du deuxième canal de signal (35.1).1), de sorte que notamment le capteur d'actionnement (30) peut être évalué par l'intermédiaire du premier canal de signalisation (30.1) indépendamment du deuxième canal de signalisation (35.1), et de préférence le capteur d'information (35) peut être évalué par l'intermédiaire du deuxième canal de signalisation (35.1) indépendamment du premier canal de signalisation (30.1).

6. Système d'accès (200) selon l'une quelconque des revendications précédentes,
**caractérisé en ce que**
le capteur d'information (35) est réalisé sous la forme d'un capteur de collision pour le véhicule (3)
et/ou **en ce que** le capteur d'information (35) est disposé de façon mobile sur une poignée de porte (10), en particulier dans un espace intérieur (20.3) de la poignée de porte (10), le capteur d'information (35) étant de préférence monté de façon mobile par rapport à une paroi (22) d'un corps de poignée de porte (20) de la poignée de porte (10) et/ou **en ce qu'**il est prévu au moins un ou au moins deux autres capteurs d'informations (35b, 35c), tous les capteurs d'informations (35) étant disposés sur et/ou dans un corps de poignée de porte (20) et/ou sur le véhicule (3) de telle sorte que la deuxième détection d'inductance (120) et d'autres détections d'inductance (130) correspondantes des autres capteurs d'informations (35b, 35c) peuvent être effectuées dans des zones de détection respectives, les zones de détection étant différentes les unes des autres.

7. Système d'accès (200) selon l'une quelconque des revendications précédentes,
**caractérisé en ce qu'**
il est prévu une poignée de porte (10) avec un corps de poignée de porte (20), la poignée de porte (10) présentant au moins un moyen d'activation inductif (60) qui est disposé dans une zone d'activation (40) du corps de poignée de porte (20), le corps de poignée de porte (20) étant configuré de manière déformable dans la zone d'activation (40), de sorte qu'une influence du moyen d'activation (60) peut être provoquée dans la zone d'activation (40) par l'action d'activation.

8. Système d'accès (200) selon l'une quelconque des revendications précédentes,
**caractérisé en ce que**
le capteur d'information (35) est disposé sur le véhicule (3) en dehors d'une action significative de l'action d'activation, et/ou **en ce que** le capteur d'information (35) est disposé sur le véhicule (3) en dehors de la poignée de porte (10), en particulier sur une partie mobile (1) du véhicule (3), de préférence sur une porte (1) du véhicule (3), et est de préférence monté mobile par rapport à la partie mobile (1).

9. Système d'accès (200) selon l'une quelconque des revendications précédentes,
**caractérisé en ce qu'**
une zone d'information (45) est prévue, en particulier sur une poignée de porte (10) et/ou sur une partie mobile (1) du véhicule (3), le capteur d'information (35) étant disposé à proximité de la zone d'information (45) de telle sorte qu'une déformation et/ou un mouvement dans la zone d'information (45) puissent être déterminés par la deuxième détection d'inductance (120), la zone d'information (45) étant de préférence disposée à distance d'une zone d'activation (40) pour l'action d'activation.

10. Système d'accès (200) selon l'une quelconque des revendications précédentes,
**caractérisé en ce que**
le capteur d'actionnement (30) est monté sur un premier point d'appui (81) et le capteur d'information (35) est monté sur un deuxième point d'appui (82), en particulier sur une poignée de porte (10) et/ou sur une pièce mobile (1) du véhicule (3), de telle sorte que le capteur d'information (35) présente par rapport au deuxième point d'appui (82) une plus grande marge de mouvement que le capteur d'actionnement (30) par rapport au premier point d'appui (81), de sorte que le capteur d'actionnement (30) est réalisé de manière moins sensible aux vibrations que le capteur d'information (35) et/ou **en ce que** le premier capteur d'actionnement (30) est monté par un palier fixe sur une poignée de porte (10), et le capteur d'information (35) est monté à cet effet d'une autre manière dans la zone de la poignée de porte (10), de préférence par un palier libre.

11. Procédé (100) pour un véhicule (3), notamment pour l'activation d'une serrure électrique (2) du véhicule (3), dans lequel il est prévu au moins un capteur d'actionnement (30) et au moins un capteur d'information (35),
**les étapes suivantes étant prévues :**
a) détection d'une déformation par une première détection d'inductance (110) du capteur d'actionnement (30),
b) la détection d'une action d'activation d'un opérateur (5) par une première évaluation de la première détection d'inductance (110),
c) la détermination d'une information supplémentaire concernant l'action d'activation par une deuxième détection d'inductance (120) du capteur d'information (35),
d) contrôle de la plausibilité de la détection de l'action d'activation par une deuxième évaluation à l'aide de l'information supplémentaire,
le capteur d'information (35) étant disposé sur le véhicule (3) de telle sorte qu'une influence perturbatrice sur la détection de l'action d'activation peut être détectée par la deuxième détection d'inductance (120),
**caractérisé en ce que**
le contrôle de plausibilité selon l'étape d) est effectué **en ce que**, à l'aide de la deuxième détection d'inductance (120), une valeur seuil est fixée pour la première évaluation pour la détection.

12. Procédé (100) selon la revendication 11,
**caractérisé en ce que**
des influences de l'environnement, de préférence un bruit de fond et/ou un mouvement de fond du véhicule (3), sont déterminées par la deuxième détection d'inductance (120) et/ou **en ce que** la deuxième détection d'inductance (120) permet de déterminer une température et/ou une déformation et/ou une vibration, notamment par une mesure d'une variation d'inductance.

13. Procédé (100) selon l'une des revendications 11 ou 12,
**caractérisé en ce que,**
en fonction de la deuxième détection d'inductance (120), la première évaluation de la première détection d'inductance (110) est influencée, la première évaluation s'effectuant notamment selon un premier type d'évaluation lorsque l'information supplémentaire remplit un premier critère, et la première évaluation s'effectuant selon un deuxième type d'évaluation lorsque l'information supplémentaire remplit un deuxième critère.

14. Procédé (100) selon l'une quelconque des revendications 11 à 13,
**caractérisé en ce que,**
en cas de détection positive de l'action d'activation, une ouverture d'une serrure électrique (2) est initiée, l'ouverture étant bloquée en particulier en fonction de la deuxième détection d'inductance (120), en particulier en cas de collision et/ou en cas de détection d'influences perturbatrices par la deuxième évaluation, qui se situent au-dessus d'une plage de tolérances
et/ou **en ce que**, pour la détection d'influences perturbatrices et/ou d'influences de l'environnement, on évalue une enveloppe et/ou une allure et/ou une information statistique d'un deuxième signal du capteur d'information (35), et de préférence, pour la détection de l'action d'activation, on compare un premier signal du capteur d'actionnement (30) directement ou indirectement au deuxième signal et/ou au résultat de la deuxième évaluation.

15. Procédé (100) selon l'une quelconque des revendications 11 à 14,
**caractérisé en ce qu'**
un système d'accès (200) peut être exploité selon l'une des revendications précédentes.
